# EUROPEAN PATENT SPECIFICATION

(11) **EP 0 574 914 B1**
(45) Date of publication and mention of the grant of the patent: **06.09.2000**
(21) Application number: 93109696.0
(22) Date of filing: 17.06.1993
(51) Int. Cl.: G03F 1/04

(54) **Apparatus for automatically making out holder indexing table for plate making**
Vorrichtung zur automatischen Herstellung von Teilscheiben zur Montage von Druckereierzeugnisse
Dispositif de production automatique pour plateaux diviseurs pour montage d'imprimerie

(30) Priority: 18.06.1992 JP 18437092; 18.06.1992 JP 18437192
(43) Date of publication of application: 22.12.1993
(73) Proprietor: MITSUBISHI PAPER MILLS, LTD., Chiyoda-ku Tokyo (JP)
(72) Inventor: Sato, Hajime, c/o Mitsubishi Paper Mills Ltd., Chiyoda-ku, Tokyo (JP); Yanaga, Masakatsu, c/o Mitsubishi Paper Mills Ltd., Chiyoda-ku, Tokyo (JP); Iguchi, Keisuke, c/o Mitsubishi Paper Mills Ltd., Chiyoda-ku, Tokyo (JP); Kajima, Norio, c/o Mitsubishi Paper Mills Ltd., Chiyoda-ku, Tokyo (JP); Sato, Yasu, c/o Mitsubishi Paper Mills Ltd., Chiyoda-ku, Tokyo (JP)
(74) Representative: Lehn, Werner, Dipl.-Ing.

(56) References cited:
- US-A- 3 982 743
- PATENT ABSTRACTS OF JAPAN vol. 015, no. 192 (P-1202), 17 May 1991 & JP 03 045941 A (MITSUBISHI PAPER MILLS LTD;OTHERS: 01), 27 February 1991,

## Description

### BACKGROUND OF THE INVENTION

The present invention relates to a table preparation method and an apparatus used for preparing a multiple-page reproducing machine plate or press plate used in printing of publications or documents.

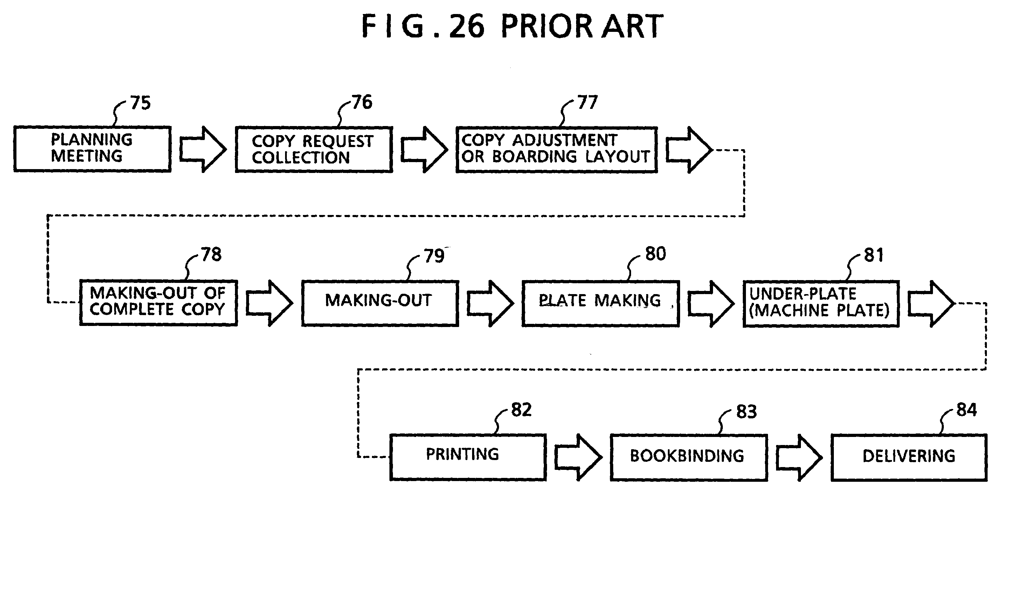

A general procedure for preparing publications is illustrated in Fig. 26 of the attached drawings. That is, first, at a planning meeting or conference 75, there are performed a collection of the material to be published, preparing of a holder indexing table (i.e. a plate planning table used for planning the arrangement of the print plates), preparing of a schedule list or table and the like. By a copy request data-collection 76, copies such as characters, illustrations and the like are secured. Layout design is decided per a single page, depending upon a copy adjustment or boarding layout 77. Thus, complete block copies are made out when making-out or preparing complete copies 79. Next, plate making 80 is performed. A machine plate or press plate is completed by a rough plate 81 through proofreading. In this manner, the procedure is brought to a procedure including the printing 82 and bookbinding 83 to the delivering 84, using the thus made-out or designed machine plate. At the making-out step 79, images of the copies of a plurality of pages are formed on a single plate. The plate prepared in this manner is used to perform printing of a front side and a rear side of the printing papers in the printing step 82. The printing papers pass through the bookbinding step 83 so that the printing papers are formed into a so-called publication of pages such as books, pamphlets and the like.

At the above-described bookbinding step 83, there are the following steps:
(1) Printing papers are folded several times in accordance with a predetermined or constant rule;
(2) Printing papers are stitched along certain one edges;
(3) Printing papers are cut along other three sides.
The printing papers stitched in this manner must fulfill the following conditions:
(1) Pages are arranged in accordance with an order;
(2) Orientations of the respective pages are completed;
(3) Positions of characters in the pages are not varied every pages; and
(4) A signature and a nigger head are located outside of the folded papers.
In order to fulfill such conditions, it is necessary to decide the position or where pages are arranged and the directions thereof with respect to a single plate. However, this includes a large variety of patterns with respect to the size or dimension of the plate, the number of foldings and, a method thereof, size or dimension of pages, a method of how to stitch, a direction of gripper margins or gripper edges by a printer, length of the gripper margins and the like.

The operation in which the copies are arranged in accordance with a decided pattern is called page reproduction. The page reproduction is such that the pages must exactly be arranged at predetermined positions in order in accordance with a holder indexing table. Also a direction of the pages is required to be in accordance with a pattern of a machine plate. Generally, although the order of the arranged pages has a regularity, the arranged pages must be located with their front and back side depending on the folding technique. Thus, it is usual or ordinary that the arrangement procedure of the pages is complicated. Further, orientations of the pages must also correctly be uniform in accordance with folding.

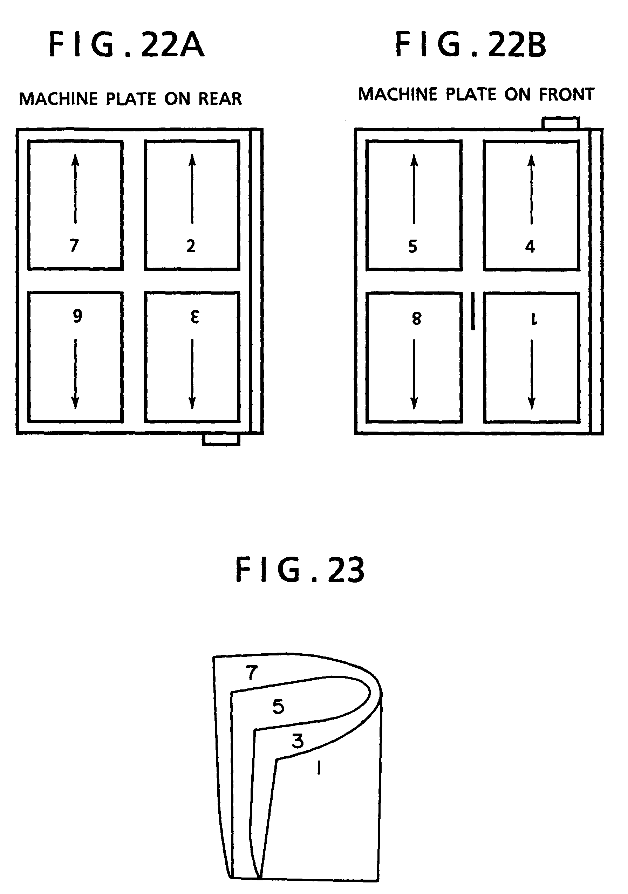

Figs. 22A and 22B of the attached drawings show an example of page reproduction to a machine plate in a case of a plain stitch. Here, the number of reproductions to a single plate is four (4). Fig. 22A indicates a machine plate for performing printing on a rear surface of a printing paper, while Fig. 22B indicates a machine plate for performing printing on a front surface of a printing paper. Numerals shown in Figs. 22A and 22B are the number of pages, and arrows indicate top edges and bottom edges of the respective pages. When the printing papers, which have been printed by the machine plate on the front surfaces and the rear surface are folded and bookbinding is performed in accordance with a predetermined folding technique as shown in Fig. 23, the pages are reproduced in a top edge direction and a bottom edge direction as illustrated in Figs. 22A and 22B such that the top edge and the bottom edge of each of the pages become complete, i.e. they are arranged under a folded condition and in a page order as shown in Figs. 22A and 22B in such a manner that the page numbers are continuous to each other in the folded condition.

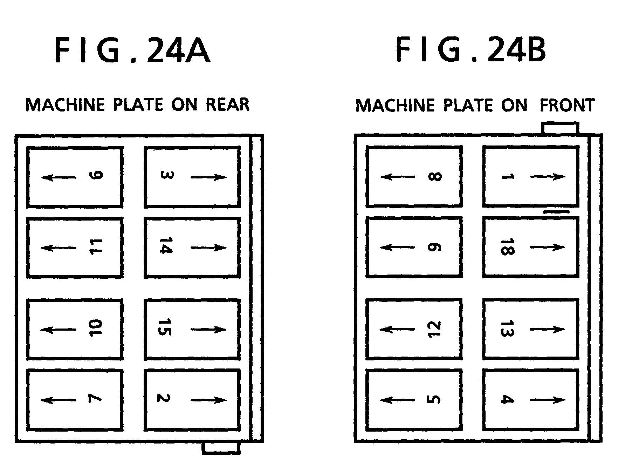

Figs. 24A and 24B show an example of page reproduction to a machine plate in the case of a plain stitch, and the number of page reproductions to a single plate is eight (8). Fig. 24A shows a machine plate for performing printing to rear surfaces of printing papers, while Fig. 24B shows a machine plate for performing printing to the front surfaces of the printing papers. Also in this case, the order of pages and top edges and bottom edges are set for every page such that the pages are continuous to each other and the top and bottom edges are correctly arranged on front and rear surfaces of the printing paper when being printed by the machine plates and being is folded in accordance with a predetermined folding technique.

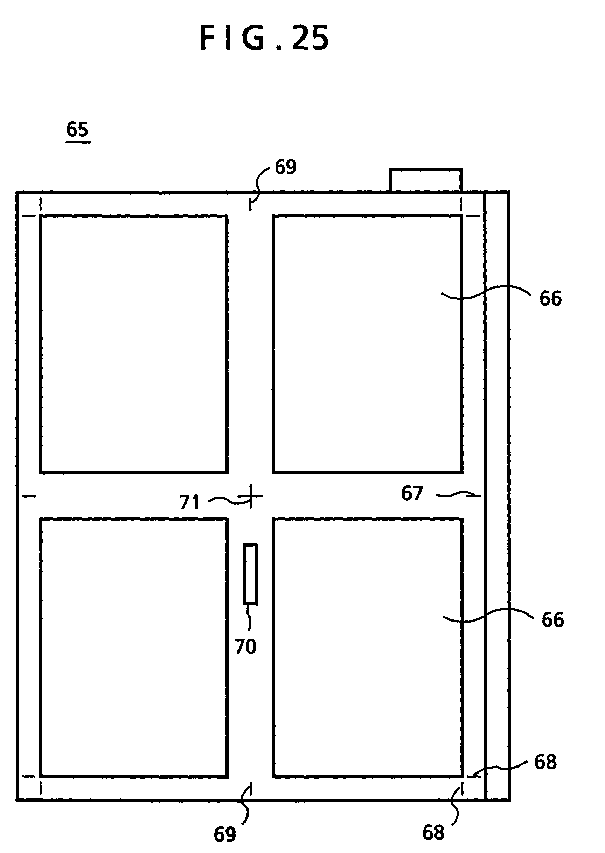

As explained above, a plurality of pages are reproduced on each of the plates in the above-mentioned manner and, in addition thereto, various kinds of margins are need to be set around the pages. Fig. 25 shows an example thereof. One plate 65 is formed with register marks 67, 68, 69 and 70 forming indexes or references for the folding and cutting steps, a nigger head 71 and the like at locations in the margins of a plurality of pages 66 including reproducing text.

In this manner, the page reproduction must correctly and accurately be performed. Up to now all of the page reproductions are performed manually. For this reason, not only skill is required, but also mistakes or errors tend to occur. In this respect, according to a multiple page reproducing method disclosed in Japanese Patent Laid-Open No. 3-45941 a reproducing operation for every plate is automatized to a certain degree and skill is not so much required regarding the reproducing operation thus reducing mistakes.

Further, the holder indexing table is made out or prepared at a planning stage, and serves as a standard for a subsequent printing operation. The holder indexing table indicates what pages are arranged respectively on the front and rear surfaces of each of the holders. However, the holder indexing table has been prepared manually. Here, a "holder" indicates a single set of machine plates on the front and rear surfaces required for performing printing on the front and rear surfaces of a single printing sheet. It is required that the holder indexing table is in agreement with a schedule of printing facility and the printing machine. Moreover, there are many factors which must be considered in the preparation stage, as the number of total pages of the printed matter, the number of page reproductions per single plate, how to stitch, the presence and absence of blank pages, the designation of reversing and two-application, and the like.

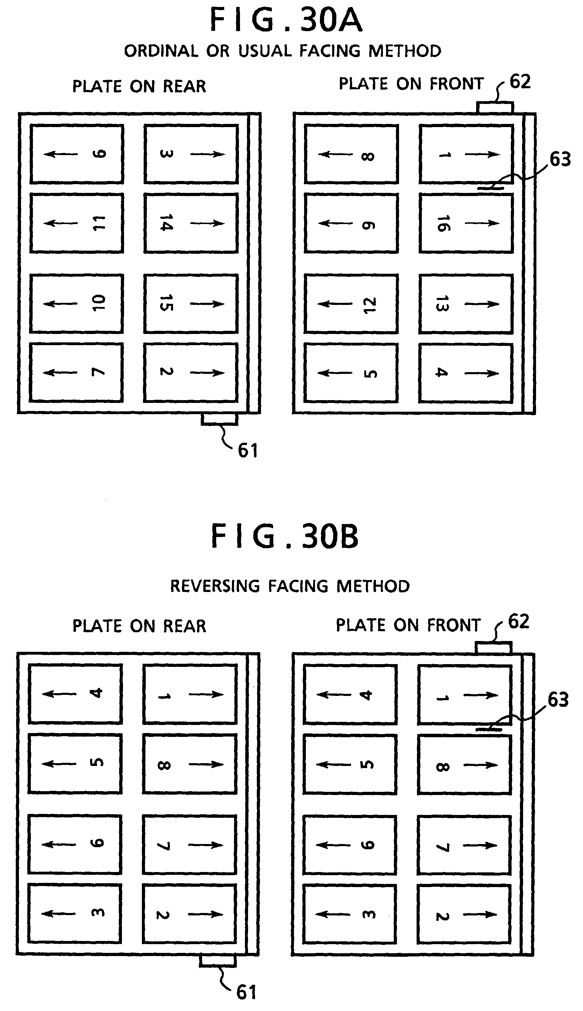

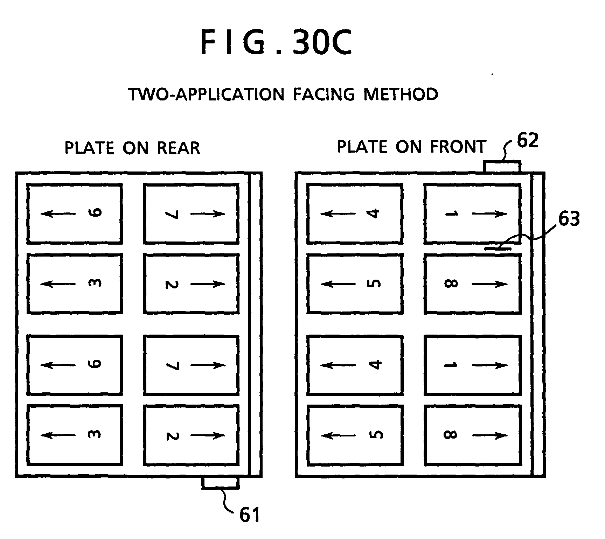

Hereinafter, the "reversing" and "two-application" procedure will be described. It is assumed that sixteen (16) pages are reproduced onto a single plate. In a normal reproduction, pages continuous to each other in the set of sixteen (16) pages, that is 16 page reproductions, are assigned or allocated to front and rear plates, as shown in Fig. 30A, so that a set of sixteen (16) pages is prepared. The reference numeral 63 denotes a signature; and 62 a needle, that is, a laterally-applied guide for laterally arranged printing papers to a reference. By contrast reversing (called also "half sheet or work and turn") and two-application reproducing methods are methods which have the same reproducing contents, for example, in which two (2) sets of the sum of eight (8) pages of 1 ∼ 8 pages are allocated to the left and the right of the plate. Fig. 30B shows an example of the reversing reproducing method, while Fig. 30C shows an example of the two-application reproducing method. If a printed sheet is cut along predetermined cutting lines in Figs. 30B and 30C, there are produced the same printed documents each having a single set of 1 ∼ 8 pages with twice the number of copies. Accordingly, when a printing sheet having only eight (8) pages is printed, there can be produced an advantage that reproduction is effectively performed without leaving the remaining half blank. In the two-application reproducing method illustrated in Fig. 30C, pages are arranged in parallel relation to the left and the right with cutting lines serving as boundaries in the plates at the front and rear surfaces thereof. In the reversing reproducing method illustrated in Fig. 30B, pages are arranged such that the font and back side of each page appears always on the side of the needle 62. By doing so, after cutting, if the printing papers are prepared or arranged on the side of the needle 62, the sheet when being printed on the front and back surface with the respective side of the print plate has the corresponding front and back sides of each page on the front and back surface at the same corresponding location. (in the two-application reproducing method, this is not unified). By doing so, a continuous bookbinding is possible.

However, the multiple-page reproducing method according to the above-described techniques requires that a plate (a machine plate) format is automatically prepared on the basis of multiple-page reproduction pattern data defining in what manner pages are allocated on a single plate, and format data such as size or dimension of a plate, size of pages, size of "ditch" and the like, and all operations are not performed automatically. That is, a mask plate and a plate of a process camera can be controlled picture-by-picture or scene-by-scene in accordance with the prepared plate format. However, it is required that copies are set onto a subject holder of the process camera manually, top and bottom edges of the copies are decided in accordance with orientation of the top and bottom edges indicated at this time, and the copies are set in accordance with the indicated order. This is inefficient, and many processing steps are required. Further, although the possibility of mistakes is reduced, mistakes with respect to the direction of the top and bottoms edges, the order of setting the copies and so on may still occur.

As described above, the holder indexing table has the following disadvantages. That is, the holder indexing table must be prepared in consideration of schedules of printing facility and a printing machine at the stage of planning. In spite of the fact that the holder indexing table is important because it serves as a standard or reference for the subsequent operation, the holder indexing table has conventionally been prepared manually. For this reason, the preparing of the holder indexing table is inefficient, and mistakes are apt to occur. Amendment or revised operation is not easy in a case where mistakes are found. Moreover, it requires skill to prepare the holder indexing table adequately to be suited for the schedule of he printing facility. Furthermore, the printing machine is operated manually in this manner and time is also required for this.

Furthermore, in order to ascertain or confirm justification of the holder indexing table, an operation was performed such that pages and an orientation thereof on the plate are written onto the papers to form sections, and the prepared sections were actually folded in accordance with the folding technique by a folding machine. If the circumstances require, a plurality of sections are stitched in accordance with the determined folding technique. The sections in this case have also been prepared manually.

Further, in recent years, so-called desktop publishing (hereinafter referred to as "DTP") in which publications are made by the use of computers have been widely used The DTP is such that editing of every page can be performed on a computer, that is, steps from the copy adjustment or boarding layout 77 to the making-out 78 of a complete copy as shown in Fig. 26 are performed on the computer. Subsequent steps are in accordance with conventional printed-matter making-out procedures.

If complete copies of every page prepared in the form of electronic information by the DTP are reproduced on plates in accordance with a plate format and a holder indexing table which are made out in the form of electronic information on the computer, and if plate information for every plate can be made out, the plate information can be used to form images or pictures electronically reproduced in the predetermined electronic form on a direct machine plate Since the picture information can be displayed on a display the making-out step 79 and the proofreading step 80 in Fig. 26 can be carried out very efficiently.

### SUMMARY OF THE INVENTION

The object of the present invention is to provide an apparatus and a method which allow the setting of a layout of pages on a set of front/back printing plates in an easy and efficient manner.

This object is solved by an apparatus according to claim 1. Furthermore, this object is solved by a method according to claim 8.

Further advantageous embodiments and improvements of the invention can be taken from the dependent claims.

One advantage of the method and the apparatus according to the invention is that the pages are managed in a unified manner and that copies of each page can be automatically reproduced, whereby operating steps for preparing the page layout are reduced, thus allowing to eliminate operation mistakes. Another advantage of the invention is that an amendment or a revision of the layout is extremely easy, for example in a case where mistakes are found or when blank pages need to be added or when the number of reproductions per plate is to be changed or modified. This is of special advantage for reproductions according to the reversing, two-application or the like printing methods. Thus, the layout preparation is optimally adapted to the printing facility and a printing machine. The invention also allows an electronic reproduction of the machine plate to allow an easy verification.

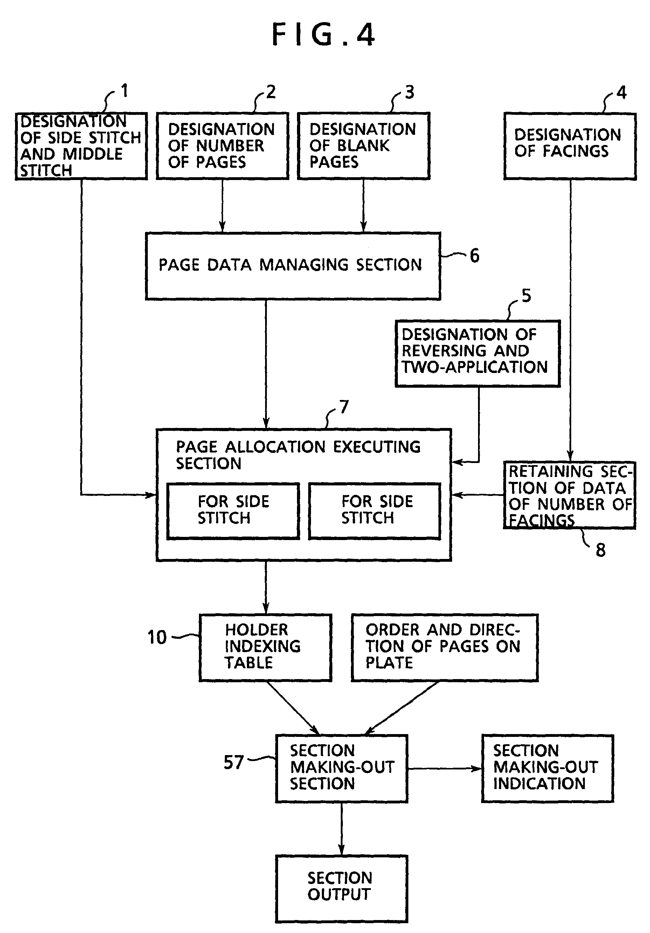

A fundamental or basic arrangement of the invention is shown in Fig. 4.

The invention, according to a first aspect, comprises an input section for inputting at least data of the number of total pages of a printed matter and data of the number of reproductions on every plate, and a page allocation executing section 7 for allocating pages corresponding only to the number of reproductions, on the basis of the inputted data. In a case where the stitching method is a side stitch, a middle stitch or the like, stiching method data can be inputted to the input portion.

The invention, according to a second aspect, comprises a designating section 2 for the number of pages, for inputting the number of total pages of a printed matter, a designating section 1 for plain stitch and middle stitch, for inputting stiching method data, a designating section 4 for the number of reproductions, for inputting data of the number of reproductions on every plate, a page data managing or controlling section 6 for preserving or storing the inputted data of the number of total pages, a data retaining or holding section 8 for the number of reproductions, for holding the inputted data of the number of reproductions, and a page allocation executing section 7 for setting the number of pages to be included into a single plate on the basis of the data of the number of facings to perform allocation of pages for every set of pages in accordance with the order which is determined by the inputted stitching method data.

The invention, according to a third aspect, resides in the fact that the input section can input blank page data, and comprises a page allocation executing section 7 capable of inserting blank pages upon page allocation on the basis of blank page data.

The invention, according to a fourth aspect, resides in the fact that it can designate the number of reproductions in different tables.

The invention, according to a fifth aspect, resides in the fact that the input section can input reversing and two-application data, and that a page allocation executing section 7 repeatedly allocates the same pages to the same plates or the same tables on the basis of the data of reversing and two-application.

The invention, according to a sixth aspect, resides in the fact that sections on respective front and rear sides of each holder can be made out by a section making-out or preparation section 57, on the basis of the prepared holder indexing table and the data expressing order and the direction of pages on a plate.

The invention, according to a seventh aspect, comprises a step of reproducing page information of a plurality of pages, such as the order of pages allocated to a plate, the top and bottom edges of the pages and the like, to input data required for preparing a single plate, to thereby set machine-plate format data, a holder-indexing setting step of preparing holder indexing data on the basis of at least data of the number of total pages of a printed matter and data of the number of reproductions for every plate, and a machine-plate information making-out or preparing step of allocating page information prepared beforehand, on the basis of machine-plate format data and holder indexing data, to make out machine-plate information required for a plate making.

The invention, according to an eighth aspect of the invention, comprises means for reproducing page information of a plurality of pages, such as the order of pages allocated to a plate, top and bottom edges of the pages and the like, to input data required for preparing a single plate, to thereby set machine-plate format data, holder-indexing setting means for preparing holder indexing data on the basis of at least data of the number of total pages of a printed matter and data of the number of reproductions for every plate, and machine-plate information making-out means for allocating page information prepared beforehand, on the basis of machine-plate format data and the holder indexing data to prepare machine-plate information required for plate making.

In the step of setting the machine-plate format data and the means for setting the machine-plate format data, a plate (machine plate) setting file is set up by inputting the required data. In the holder-indexing setting step or the holder-indexing setting means, a holder indexing list or table is prepared in which the pages are allocated for every holder by inputting the required data. The plate information preparing step or the plate information preparation means performs allocation in the order expressed on the holder indexing data in accordance with arrangement expressed on the plate setting file to allocate the page information prepared beforehand the allocating order to prepare machine-plate information required for plate making. The machine-plate information is inputted to an output machine, such as an image setter or the like, to form images on the plates, so that there can be produced a machine plate.

The above described aspects of the invention provide the following advantages.

In the invention according to the first aspect, if the data of the number of total pages of the printed matter, the data of the number of reproductions every plates and the stichting method data are inputted from the input section, the page allocation executing section 7 allocates the pages of only the number of reproductions on the basis of these data.

In the invention according to the second aspect, if the data of the number of total pages of the printed matter, the data of the number of reproductions for every plate and the stitching method data are inputted from the input sections 2, 4 and 1, the data of the number of total pages are preserved in a page data managing section 6, and the data of the number of reproductions are retained in the retaining section 8. In the page allocation executing section 7, the holder number required to print the number of total pages is decided or determined by the data of the number of total pages and the data of the number of reproductions. The number of pages to be entered into a single plate is set on the basis of the data of the number of reproductions. Allocation of the pages for every plate is performed for each holder of the determined number of holders, in accordance with the order determined by the stitching method data. The page allocation executing section 7 prepares a holder indexing table 11 for plain stitch or a holder indexing table 12 for middle stitch corresponding to the stitching method data is made out in accordance with allocation of the pages, to be output as a holder indexing table 10.

In the invention according to the third aspect, if blank page data are inputted from the designating or appointing section 3 of blank pages, the page allocation executing section 7 inserts blank pages on the basis of the page data upon allocation of the pages.

In the invention according to the fourth aspect, if the number of reproductions is designated regarding each holder, pages are allocated for the designated number of reproductions for each holder.

In the invention according to the fifth aspect, if the data of reversing or two-application are inputted from the reversing and two-application designating section 5, the page allocation executing section 7 repeatedly allocates the same pages to the same plate or the same holder on the basis of the data.

In the invention according to the sixth aspect the preparation of the sections is instructed or indicated, whereby the section making-out section 57 makes out sections of the designated plate. Thus, it is possible to display the sections on a screen of the computer or to output the sections from the printer.

### BRIEF DESCRIPTION OF THE DRAWINGS

Fig. 1 is a functional block diagram showing a fundamental or basic arrangement of a page reproducing method and an apparatus according to the invention;
Fig. 2 is a functional block diagram in which the page reproducing method and the apparatus therefor are rewritten;
Fig. 3 is a front elevational view showing an example of an initial setup according to an embodiment of the page reproducing method and the apparatus of the invention;
Fig. 4 is a functional block diagram showing a basic arrangement of a holder indexing table making-out or preparation apparatus capable of being applied to the invention;
Fig. 5 is a front elevational view showing an example of an initial setup of the holder indexing table making-out apparatus;
Fig. 6 is a front elevational view showing an example of a setup when preparing a holder indexing table;
Fig. 7 is a front elevational view showing an example of a still another setup when preparing the holder indexing table (i.e. a plate planning table);
Fig. 8 is a front elevational view showing an example of a still another setup when preparing the holder indexing table;
Fig. 9 is a front elevational view showing an example of a still another setup when preparing the holder indexing table;
Fig. 10 is a front elevational view showing an example of a still another setup when preparing the holder indexing table;
Fig. 11 is a front elevational view showing an example of a still another setup when preparing the holder indexing table;
Fig. 12 is a front elevational view showing an example of a setup when preparing the holder indexing table in a case where how to stitch is different from the above;
Fig. 13 is a front elevational view showing an example of a still another setup when preparing the holder indexing table;
Fig. 14 is a front elevational view showing an example of a still another setup when preparing the holder indexing table;
Fig. 15 is an arrangement view showing the order of page allocation for a number of reproductions to each plate;
Fig. 16 is an arrangement view showing the relationship between arranging element numbers and page numbers, for a case where there is a blank page and a case where there is no blank page;
Fig. 17 is an arrangement view showing the relationship between a table number and a number of reproductions of a table, for a case where there is a change during preparation and a case where there is no change during the preparation;
Fig. 18 is a view showing an example of making-out or preparing of machine-plate information according to the above embodiment of the invention;
Fig. 19 is a view for explanation, showing an another example of preparing machine-plate information according to the above embodiment of the invention;
Fig. 20 is a front elevational view showing an example of various kinds of parameters for a plate format;
Fig. 21 is a block diagram showing an example of a printing system to which the page reproducing method and the apparatus therefor are applied, according to the invention;
Fig. 22 is a front elevational view showing an example of page allocation to a plate of a single table;
Fig. 23 is a perspective view showing an example of folding a printing paper;
Fig. 24 is a front elevational view showing an another example of page allocation to a plate of a single table;
Fig. 25 is a front elevational view showing an example of various kinds of marks on a page of a single plate;
Fig. 26 is a flow chart schematically showing a general procedure in a case where publications are manufactured;
Fig. 27 is a front elevational view showing a part of an example of sections outputted on the basis of a holder indexing table which is made out in accordance with the above-described embodiment;
Fig. 28 is a front elevational view showing another part of the example of the sections;
Fig. 29 is a view showing another example of the blank page setting method; and
Fig. 30 is a front elevational view showing, in comparison, a conventional reproducing method, a reversing reproducing method and a two-application reproducing method.

### DESCRIPTION OF THE EMBODIMENTS

A page reproducing method, an apparatus therefor and an apparatus for automatically making out i.e. preparing a holder indexing table for plate making, according to the invention, will be described below with reference to the accompanying drawings.

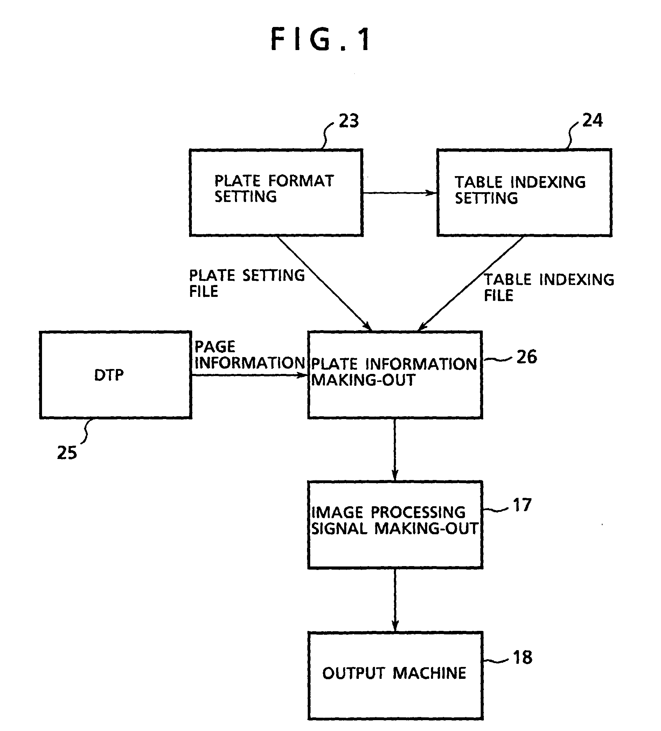

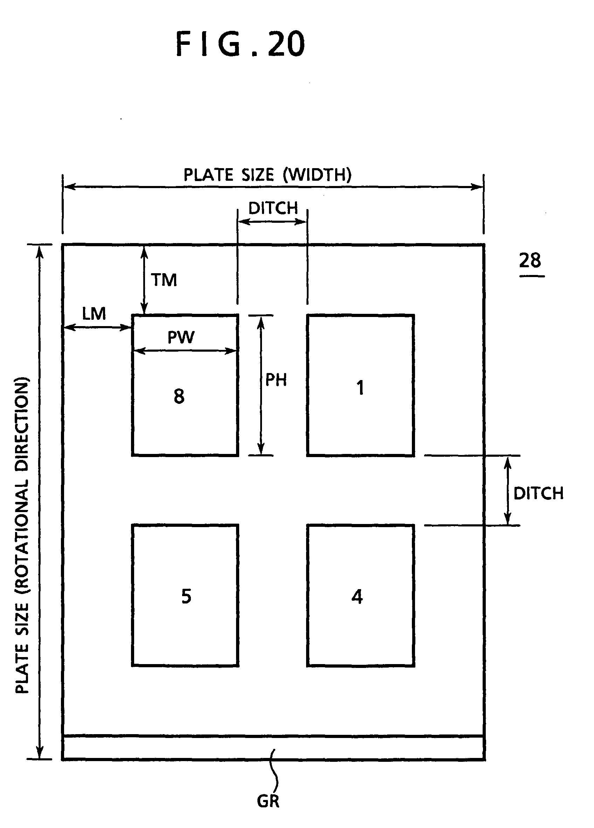

In Fig. 1, a plate-format setting step 23 is a step of inputting various kinds of data required for multiple-page reproduction, to thereby set up a plate format by a method substantially the same as that disclosed in the aforesaid Japanese Patent Laid-Open No. 3-45941. The various kinds of data required for multiple-page reproduction include size or dimension in a widthwise direction and a rotational direction of a plate, a widthwise size PW of pages, a longitudinal size of the pages PH, "ditch" in a widthwise direction between pages, "ditch" in a longitudinal direction between pages, a top margin TM, a left-hand margin LM, gripper margin width GR and the like, as shown in Fig. 20. In addition, there are various kinds of marks for the pages, for example, register marks such as sections or the like, signatures, nigger heads and the like. Further, there are defined the order of pages allocated to plates, top and bottom edges of each page and the like. In the plate format setting step 23, a plate (machine plate) format as shown in Fig. 20 is set up by inputting these various kinds of data. The set up or prepared plate format is stored in a plate setting file in the form of electronic information.

In Fig. 1, a holder-indexing setting step 24 is a step of inputting data the number of total pages of the printed matter, data of the number of reproductions for each plate, and optionally stitching method data, to thereby prepare a holder indexing table for allocating pages to each table. Therefore, the holder indexing table serves as a kind of plate planning table. That is, the number of pages to be entered into a single plate is set on the basis of the number of reproductions with respect to the number of holders required to print the number of total pages, the number of total pages, and the number of reproductions of each plate, to prepare a holder indexing table in which pages are allocated for the number of set pages, and every holder within a number of holders is found by computation, in accordance with the order determined by how to stitch data. The prepared holder indexing table is stored in the holder indexing file in the form of electronic information.

In Fig. 1, a DTP 25 can edit copies in which characters or pictures, photos or copies are mixed with each other, on a computer, as known well. A plenty of edited page information can be preserved in the form of electronic information.

The plate setting file made out and preserved by the plate format setting step 23, the holder indexing file made out and preserved by the holder-indexing setting step 24, and the page information prepared by the DTP 25 are applied to a plate information making-out step 26. In the plate information making-out step 26, the numbers expressed on the holder indexing file are allocated in order, while referring to the plate setting file and the holder indexing file, in accordance with the order of arrangements expressed on the plate setting file. The page information prepared by the DTP 25 is allocated in accordance with the allocation order. Thus, plate information required for plate making is prepared. More specifically, if the plate setting file as shown in Fig. 20 is used, the numbers expressed on the holder indexing file are arranged in order of the numbers expressed on a plate setting file 28, and the page information is allocated in order in accordance with the order of numbers.

Thus, as shown in Figs. 22A and 22B and Fig. 24A and 24B, the page information for every single page is allocated in predetermined order, in accordance with the plate setting file and the holder indexing file, for every plate on the front and rear sides of each holder. Further, the plate information is made out in the form in which various kinds of sizes are set and various kinds of marks are arranged in accordance with the plate setting file. The plate information is electronic information and the plate setting file, the holder indexing file and the page information are integrated with each other. The plate information is inputted to the image processing signal making-out step 17. In the image processing signal making-out step 17, the plate information is converted to a signal required to form an image at the output machine 18 such as an image setter or the like. The converted signal is inputted to the output machine 18. The output machine 18 has, for example, a laser scanner to form the image on a direct machine plate or the like in accordance with the inputted plate information. The machine plate in which the image is formed is developed by a developing processor so that the machine plate can be used for printing.

The plate format setting step 23, the holder-indexing setting step 24, the page information making-out step due to the DTP 25, and the plate information making-out step 26, described above, can all be processed within the computer. Furthermore, in the above-described embodiment, the above steps constitute a page reproducing method. However, if the above-mentioned steps are carried out by a respective function realizing means within the computer, the aforementioned steps constitute respective means of page reproducing device.

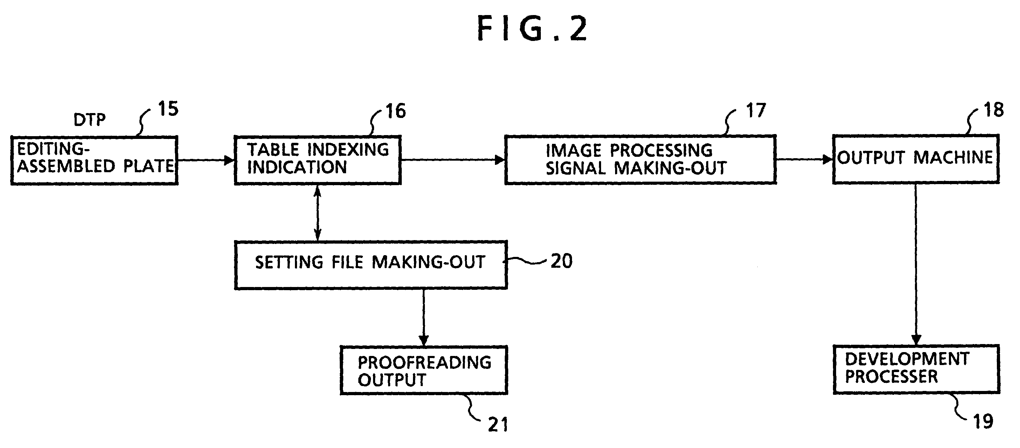

Fig. 2 shows the embodiment from an another angle. In Fig. 2, an editing composition 15 due to the DTP comprises complete copies of all pages prepared for every single page, and is preserved as electronic information. The editing composition 15 is allocated for every single page for each of the front and rear sides of each holder on the basis of the holder indexing file which is prepared as described previously, at the holder-indexing indicating step 16. Here, various kinds of parameter information for the plate format are also inputted from the plate setting file as prepared in a setting file making-out step 20. On the basis of the various kinds of parameter information, a page size, a size of ditch, and various kinds of register marks such as sections and positions thereof are designated. Since the holder indexing file is also in the form of electronic information, the holder indexing file is outputted as electronic information with which the editing composition, the holder indexing file, and the plate setting file are integrated. The setting file can be outputted from a laser printer or the like in a proofreading output step 21, whereby it is possible also to perform proofreading. The image processing signal preparation portion 17 outputs a signal required to form an image by an output machine 18 as described previously on the basis of the output from the holder-indexing indicating step 16 to the output machine 18. The output machine 18 forms an image onto a direct machine plate or the like in accordance with the input signal. The machine plate on which the image is formed is developed by a developing processor 19.

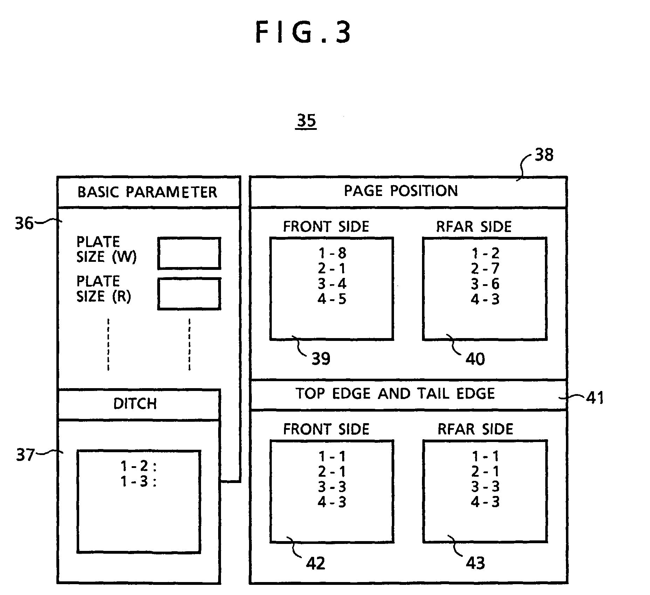

As described above, functions of the respective constitutional portions of the apparatus according to the invention can be realized by a computer software on a computer Fig. 3 shows an example of an initial scene or setup for setting various kinds of parameters required for a page reproduction for each plate. An initial scene 35 consists of a display section 36 for displaying fundamental or basic parameters such as a plate size, a gripping margin or a gripper edge, a page size and the like, a display section 37 for displaying "ditch", that is, a size between a page and a page, a reproducing display section 38 having a page-position display portion 39 regarding a plate of a front side and a page-position display section 40 regarding a plate of a rear side, a top and bottom edge display section 41 having a display portion 43 for a top edge and a bottom edge regarding a plate on the front side and a display portion 43 for a top edge and a bottom edge regarding a plate on the rear side. Data inputted from the input portion are displayed on the respective display sections.

Next, a specific or exemplified example of the holder-indexing setting step 24 or the holder-indexing setting means will be described. Fig. 4 shows a basic arrangement of the holder-indexing setting step. In Fig. 4, data of how to stitch (stitching method data) regarding a side stitch or a middle stitch are inputted at the designating section 1 of the side stitch and the middle stitch. At the designating section 2 of the number of pages, data of the number of total pages of the printed matter are inputted. At the designating section 3 of the blank pages, data of the blank pages are inputted. At the designating section 4 of the number of reproductions, data of the number of reproductions for every plate are inputted. At the designating section 5 of the reversing and two-application, data of the reversing and the two-application are inputted. The holding section 8 of the data of the number of reproductions stores the data of the number of total pages inputted in order. When the blank page data are inputted from the designating section 3 of the blank pages, the holding section 8 of the data of the number of reproductions stores the data of the number of pages equal to or less than the blank pages in shifting in order.

When the number of reproductions with respect to the holder, that is the designating section 4 for the number of reproductions, is designated, the holding section 8 for the data of the number of reproductions holds the same data of the number of reproductions regarding the holders subsequent to the holders. The page allocation executing section 7 sets the number of pages to be entered into a single plate on the basis of the data of the number of reproductions, with respect to the number of holders required to print the number of total pages by the data of the number of total pages preserved in the page data managing section 6 and the data of the number of reproductions held in the data holding section 8. In accordance with the order which is determined by the data of how to stitch inputted, allocation of pages per the number of pages set, for each holder within the scope of the number of holders found by computation is performed. A holder indexing table 10 for the side stitch or the middle stitch is made out in accordance with the data of how to stitch.

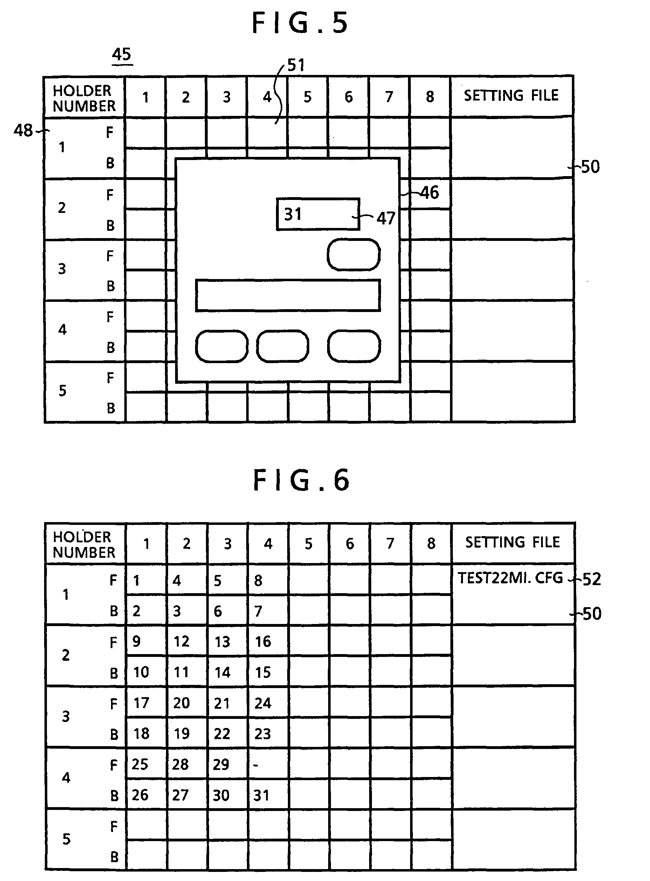

Next, a specific procedure of operation and operation of the holder-indexing setting step will be described. Fig. 5 shows an example of an initial scene of the holder indexing table making-out mode. If setting is made in the holder indexing table making-out mode, an initial scene 45 as shown in Fig. 5 is displayed. The initial scene 45 comprises a holder-number display section 48 with a plate F on the front side and a plate B on the rear side serving as a single unit, a holder-indexing display section 51, and a setting-file display section 50. At the time the initial picture 45 is called, the holder-indexing display section 51 and the setting-file display section 50 are blank. In view of this, if the setting file is called by such operation that a cursor, for example, is moved to the uppermost stage of the setting file display section 50 so that execution is performed, a sub-window 46 appears. There is a display section 47 of data of the number of total pages, on the sub-window 46. If the data of the number of total pages are inputted from the input section, this is displayed on a display section 47.

Now, a case where a single blank page is added to a coy of 31 pages to a location between the tenth page and the eleventh page to make a book of the number of pages of 32 pages is considered. Further, first, second and fifth holders are brought to 4-facing (4 pages), third and fourth holders are brought to 2-facing (2 pages) and bookbinding is performed by side stitch.

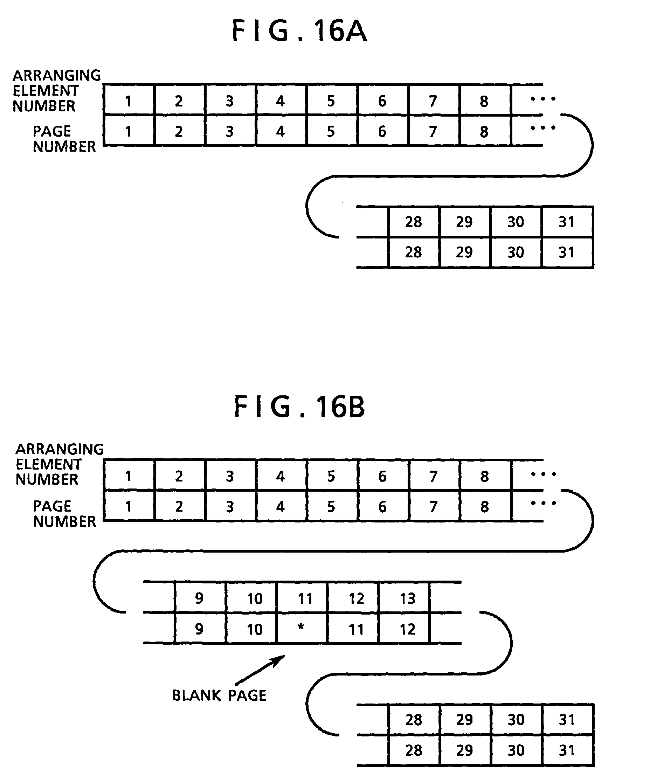

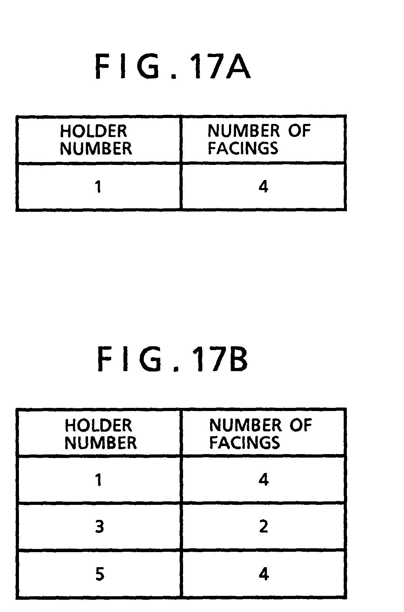

First, the number of pages except for blank pages, that is, the number of total pages of an existing document, the number of reproductions of a first holder and how to stitch are inputted as basic parameters. By the fact that the number of pages [31] except for the blank pages are inputted, an arrangement having, as elements thereof, first ∼ thirty-first pages as shown in Fig. 16A are made up on the page data managing section 6 shown in Fig. 4. A table causing the number of holders inputted and the number of facings thereof to correspond to each other is prepared, on the data retaining section 8 for the number or facings shown in Fig. 4. Figs. 17A and 17B show an example of this table. In a case where only the number of reproductions of a first holder is set as described above, only the number of reproductions of the first holder is set as shown in Fig. 17A. If the number of reproductions is altered or modified regarding a holder following the first holder, the data of reproduction are held for every modification as shown in Fig. 17B. In this connection, the number of reproductions of the number of holders which are not expressed on this table is such that the number of reproductions of the holder of the numeral closest to that equal to or less than the number within the table is referred.

At the page allocation executing section 7 shown in Fig. 4, side stitch is designated whereby processing for side stitch is performed. The page allocation executing section 7 refers to the data retaining section 8 for the number of reproductions, and judges that all the holders subsequent to the first holder is 4-facing. Regarding the first holder, the arrangement of the page data of the page data managing section 6 is referred to such that the four (4) pages on the front side, four (4) pages on the rear side and the total eight (8) pages on the following order:
front => rear => rear => front => front => rear => rear => front
The pages are allocated from the head of the arrangement.

The order in which the pages are allocated on a holder is always as follows as described above.
front => rear => rear => front => front => rear => rear => front => ......

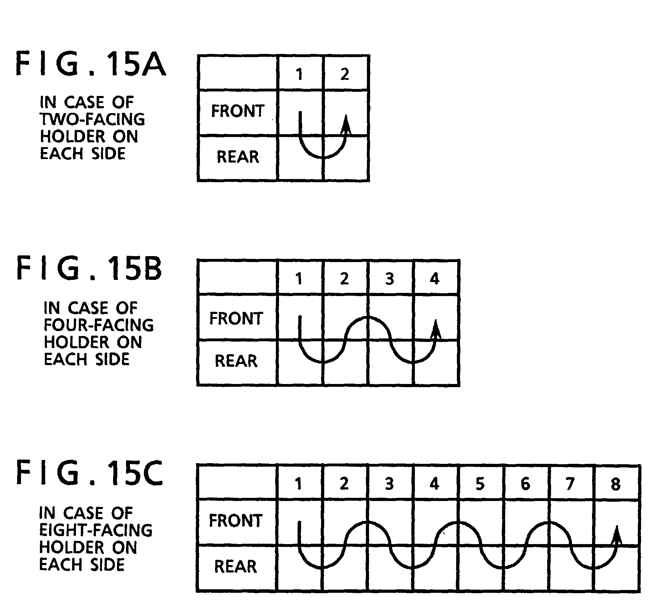

Figs. 15A, 15B and 15C show an order of the page allocation. Fig. 15A shows a case of a holder of 2-facing for each face (i.e. 2 pages on the front and rear surface, respectively) Fig. 15B shows a case of a holder of 4-facing for each face. Fig. 15C shows a case of a holder of 8-facing for each face. As will be seen from Figs. 15A, 15B and 15C, the order of allocation does not rely upon the number of reproductions. Further, in a case also of middle stitch, there is no change in the way that pages are allocated on the basis of this order. Similarly to holders subsequent to the second holder, the remaining arranging elements are subsequently allocated, whereby an original holder indexing table can be prepared.

Fig. 6 shows an example of the holder indexing table which is made out and displayed in this manner. As can be seen from Fig. 6, the holder indexing table serves as a kind of plate planning table and hereinafter both terms are used analoguously. A file 52 displayed on a setting file display section 50 shows a file of 4-facing. As described previously, data of the inputted number of total pages are [31]. The called file 52 becomes a file such that the number of reproductions per each plate is four (4) pages of the number of reproductions. Accordingly, allocation is performed to each plate to the sum of 8 (eight) plates for each four (4) pages, and to four (4) holders as the number of holders. Moreover, since the number of pages is [31], pages are not allocated to No. 4 of the plates on the front side of the fourth holder. Thus, No. 4 of the plates on the front side of the fourth table is left or remains blank.

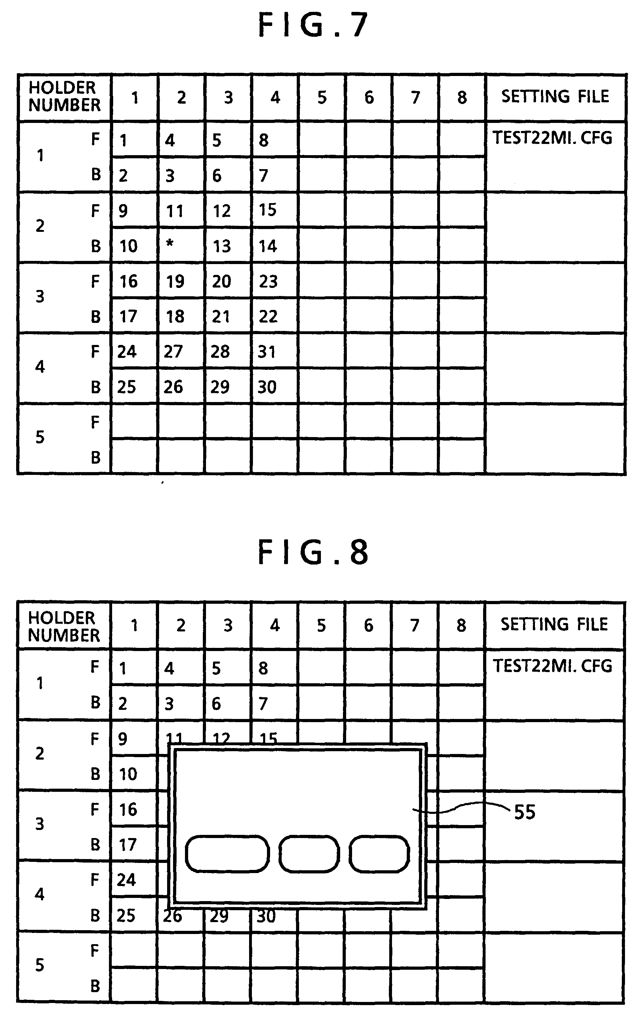

Next, inputting is performed such that a blank page is inserted into a location between tenth (10) page and eleventh (11) page, from the designating section 3 for blank pages illustrated in Fig. 4, That is, a blank page is inserted into a location between the tenth (10) page and the eleventh (11) page in the arrangement of the page data of the page data managing section 6, as shown in Fig 16B. On the basis of the arrangement of the page data newly changed or altered, the page allocation executing section 7 refers to the data retaining section 8 for the number of reproductions, and allocates the pages in accordance with the aforesaid allocation order. An example of the holder indexing table made up in this manner is shown in Fig. 7.

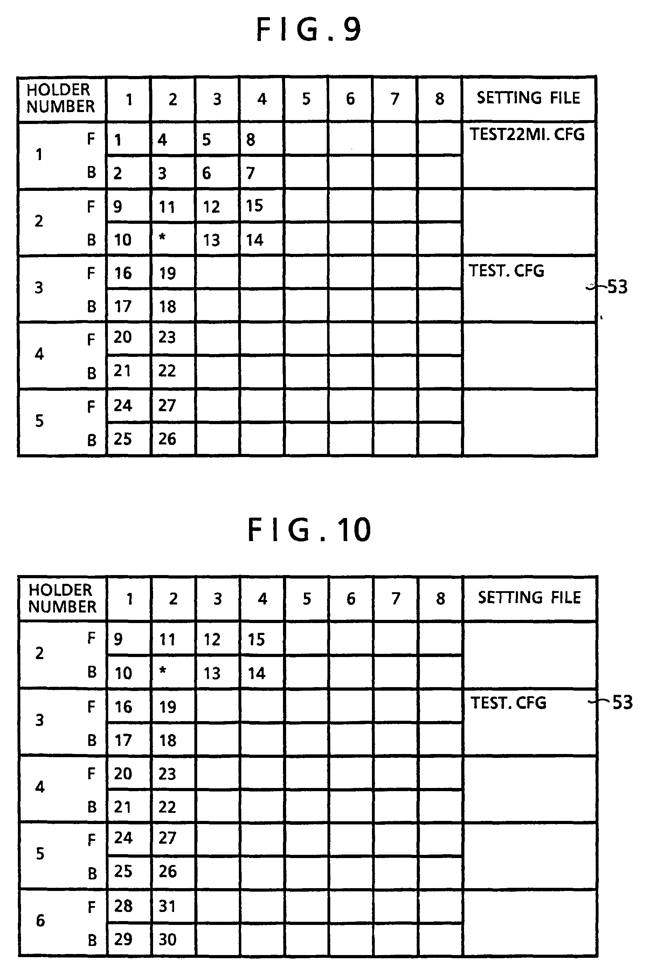

Next, it is assumed that data of 2-facing (2 pages on the front or back surface) is designated for the third (3) table and the following tables. Fig. 8 shows an example of a scene or a picture at the time the data of reproduction are altered or changed. The file 53 of 2-facing is designated as a setting file of the third (3) holder, in accordance with an indication or instruction of a sub-window 55 displayed. In this manner, the holder number of the data retaining section 8 of the number of facing data and the corresponding table of the number of reproductions are modified or changed. The page allocation executing section 7 again performs allocation of pages on the basis of newest or latest data. Fig. 9 shows the holder indexing table in a case where the file is modified or changed in this manner. From the number of holders and the corresponding table of the number of reproductions, eight (8) elements of the arrangement of the page data are allocated to the first holder and the second holder. However, four (4) elements are allocated to holders subsequent to the third holder. Furthermore, since the number of required holders increases for this reason, pages are allocated till the number of holders required, as shown in Fig. 10.

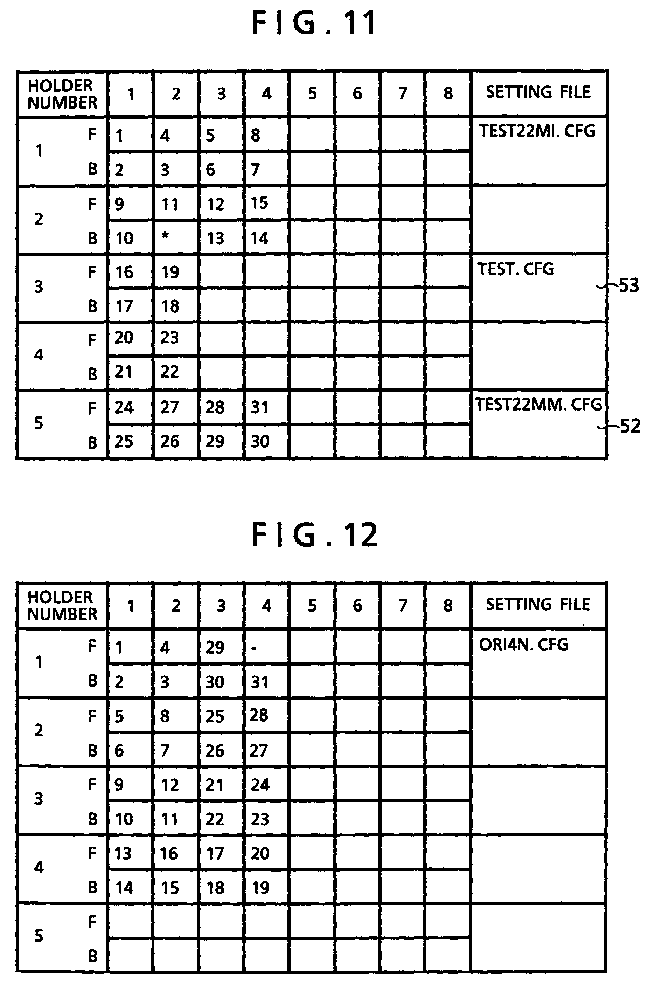

Further, it is assumed that the data of 4-facing are again designated to the fifth (5) holder. Also in this case, the number of holders of the retaining section 8 of the data of the number of reproductions and the corresponding table of the number of reproductions are changed or altered in procedure similar to that described above. Fig. 17B shows the corresponding table changed in this manner. The page allocation executing section 7 again performs allocation of pages on the basis of the newest or latest data. Fig. 11 shows the holder indexing table for a case where a file is changed in this manner. From the holder number and the corresponding table of the number of reproductions, eight (8) elements of the arrangement of the page data are allocated to the first and second holders, four elements are allocated to third and fourth holders, and eight (8) elements are allocated to the fifth (5) holder. In this manner, a final holder indexing table is prepared.

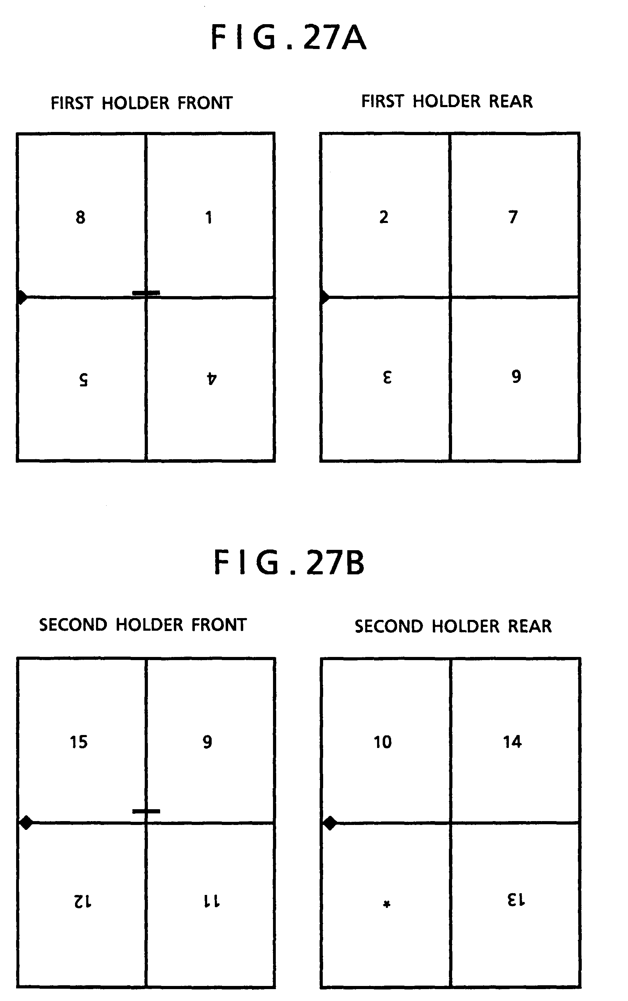

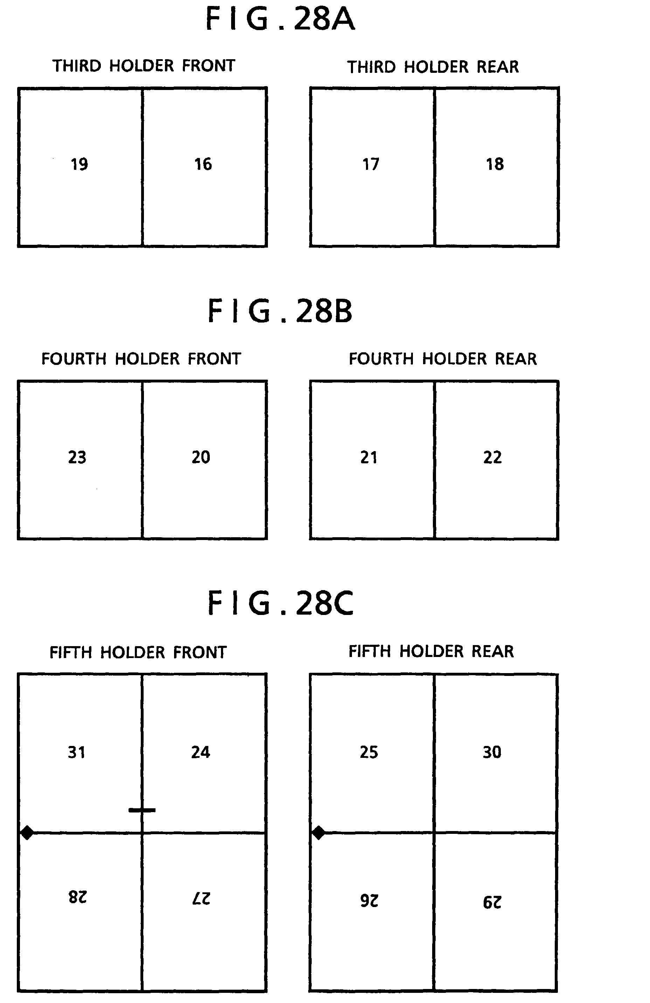

Moreover, here, as shown in Fig. 4, if section making-out indication is performed to all of the plates, the section making-out section 57 makes out sections of each plate on the basis of the order and the direction of the pages on the plate of the setting file and the holder indexing table 10, and displays the same on the picture or outputs the same to a printer. Allocation of the pages at this time is such that the pages of the holder indexing table are allocated in order from the left page from a portion in which the order of the pages of the setting file is low. Figs. 27A and 27B and 28A, 28B and 28C show examples of sections according to the present embodiment which are outputted to the printer in this manner. Further, making-out indication of the sections can be performed with respect only to a specific plate.

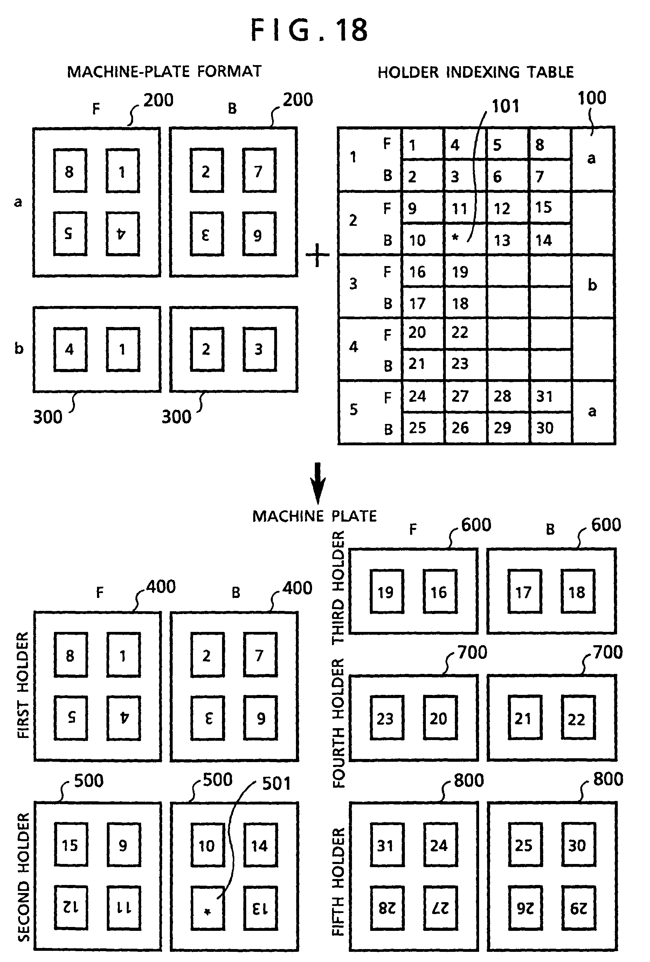

Next, a procedure of specific reproducing operation will be described with reference to Fig. 18. In Fig. 18, the reference numeral 100 indicates a holder indexing table; 200, a plate format expressed by a setting file name [a]; 300, a plate format expressed by a setting file name [b]; and 400, 500, 600, 700 and 800, reproducing results of first, second, third, fourth and fifth holders. Moreover, the reference character F indicates a front surface; and B, a rear surface. Facing of each holder will hereunder be described.

The facing i.e the layout of first table: It will be seen from a holder indexing table 100 of the first holder that the plate format is [a], that is, the plate format is a plate format indicated by the reference numeral 200 in Fig. 18. Facing is performed such that reproduction is performed in order in which the page number indicated in the plate format 200 is small, from the left to the right of the holder indexing table, that is, pages 1, 4, 5 and 8 are reproduced on the front surface, and pages 2, 3, 6 and 7 are reproduced on the rear surface. The reproducing results are indicated by the reference numeral 400.

Facing (layout) of second holder: As described previously, since a plate format in this case is likewise [a], the page order reproduced is the same as that of the first holder. In accordance with this order, pages 9, 11, 12 and 15 in the holder indexing table are reproduced on the front surface, and pages 10, blank, 13 and 14 are reproduced on the rear surface. Reproduction of the second table is performed. The reproducing results are indicated by the reference numeral 500. The reference numeral 101 in the holder indexing table 100 and the reference numeral 501 in the reproducing results 500 of the second table indicate blank pages.

Facing (layout) of third holder: Since it will be seen from the holder indexing table that the plate format is [b], that is, the plate format is a plate format indicated by the reference numeral 300 in Fig. 18, pages 16 and 19 in the holder indexing table are reproduced on the front surface, and pages 17 and 18 are reproduced on the rear surface, in accordance with the order of pages shown in Fig. 18. Thus, reproduction of third table is performed. The reproducing results are shown by the reference numeral 600. Regarding fourth holder and fifth holder, reproduction is performed similarly.

Next, a case of saddle stitch will be described. An arrangement of the page data of the page data managing section 6, and a correspondence holder between the holder number and the number of reproductions of the data retaining section 8 of the number of reproductions are the same as those in the case of the side stitch. First, function of the page allocation executing section 7 when the number of reproductions regarding holders (in the present embodiment, first, second and fifth holders are four sides on each of the front and rear sides, and third and fourth holders are two sides) and the number of pages of the existing copy except for the blank pages ([31] in this embodiment) are inputted will be described.

At the page allocation executing section 7, the number of holders finally prepared are computed on the basis of a corresponding table of the number of holders and the number of reproductions, and the number of elements of the arrangement of the page data. The number of all pages allocated to all respective holders is computed. The number of total pages capable of being allocated to all the holders with respect to the number of elements of the arrangement of the page data, that is, the number of remaining or surplus pages is computed. Here, the number of elements of the arrangement of the page data is 31. In order to allocate all the 31 pages, 8 pages are required for the first holder, 8 pages are required for the second holder, 4 pages are required for the third holder, 4 pages are required for the fourth holder; and 8 pages are required for the fifth holder. Thus, in total four holders are required. The number of total pages at that time is 32. Thus, the number of remaining pages is 1.

Half the number of pages reproduced to the respective holders is allocated from the beginning of the arrangement of the page data. Further, the remaining half is allocated from the last of the arrangement of the page data. At this time, pages are allocated in such a manner as to be returned to a first portion from the last portion of the holder indexing table (plate planning table), with the last portion jumped only through the number of remaining pages. Here, as shown in Fig. 12, 8 pages are reproduced at the first holder. However, the first portion of the arrangement of the page data, that is, from page 1 to page 4 of the page data, are allocated to the area that is halt the beginning of the holder indexing table (plate planning table), i.e. first four page area. Remaining four page area of the holder indexing table (plate planning table) is filled as follows by page data. First, remaining page is one, so that the last one page area of the holder indexing table (plate planning table) is jumped, i.e. the last one page area is not filled with page data. Next, other three page areas are filled with page data, the page number of which is from 31-29 in reverse order.

At the second holder, the allocation of page data is as follows. Namely, the page data, that is subsequent part of the pages allocated to the front half portion of the first holder, i.e. from page 5 to page 8, is allocated to the front half portion of the holder indexing table (plate planning table).

The rear half portion of the holder indexing table (plate planning table) is filled by the page data as follows. That is, the page data, that is subsequent part of the pages allocated to the rear half portion of the first holder, in reverse order, that is from page 28 to page 25, is allocated to the rear half portion of the holder indexing table (plate planning table).

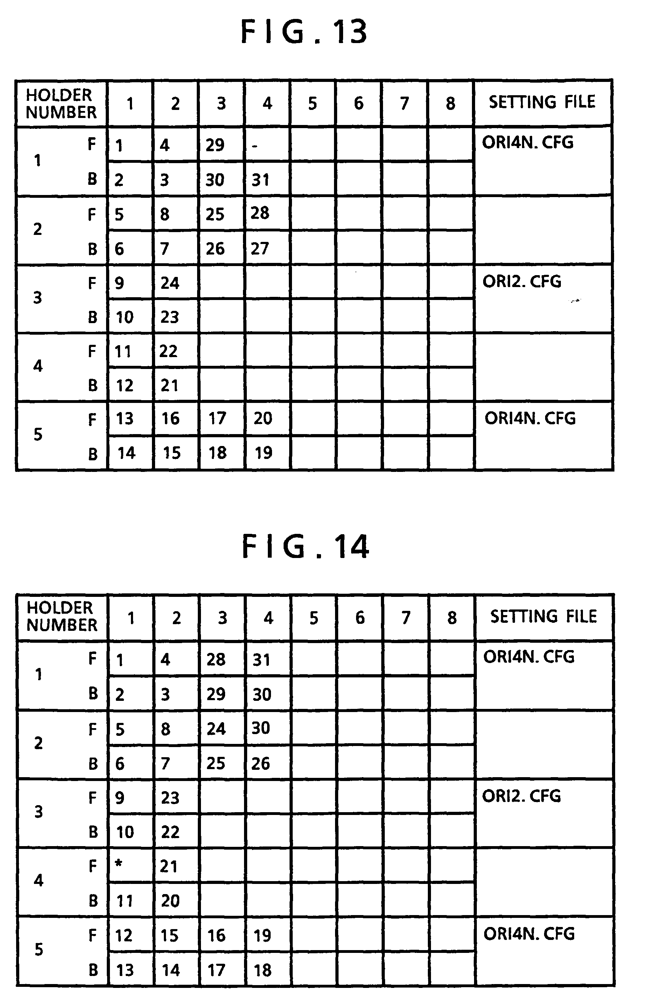

At the third holder, since the number of pages allocated to the table is four (4) pages, allocation is similarly performed to the front half portion and the rear half portion through 2 pages. Specifically, pages 9 and 10 are allocated to the front half portion, while pages 24 and 23 are allocated in this order to the rear half portion. Similarly, at the fourth holder, pages 11 and 12 are allocated to the front half portion, while pages 22 and 21 are allocated to the rear half portion. At the fifth holder, pages 13-16 are allocated to the front half portion, while pages 20-17 are allocated to the rear half portion. An example of the holder indexing table made out in this manner is shown in Fig. 13.

If an indication that a blank page is to be inserted into a location between the tenth page and the eleventh page is given in the holder indexing table illustrated in Fig. 13, the arrangement of the page data of the page data managing section 6 is changed similarly to the case of the side stitch. Fig. 14 shows an example of the holder indexing table at the time the blank page is inserted. When the arrangement of the page data is changed as described above, processing described until now is subsequently executed again. Here, since the element of the arrangement of the page data is 32 by insertion of the blank page, as shown in Fig. 16B, the number of remaining page is 0 (zero). pages 31-28 are allocated to the rear half portion of the first holder. Allocation is performed to the rear half portion of the holder subsequent to the second holder, with the order shifting one page. In this manner, a new holder indexing table is made out and is displayed.

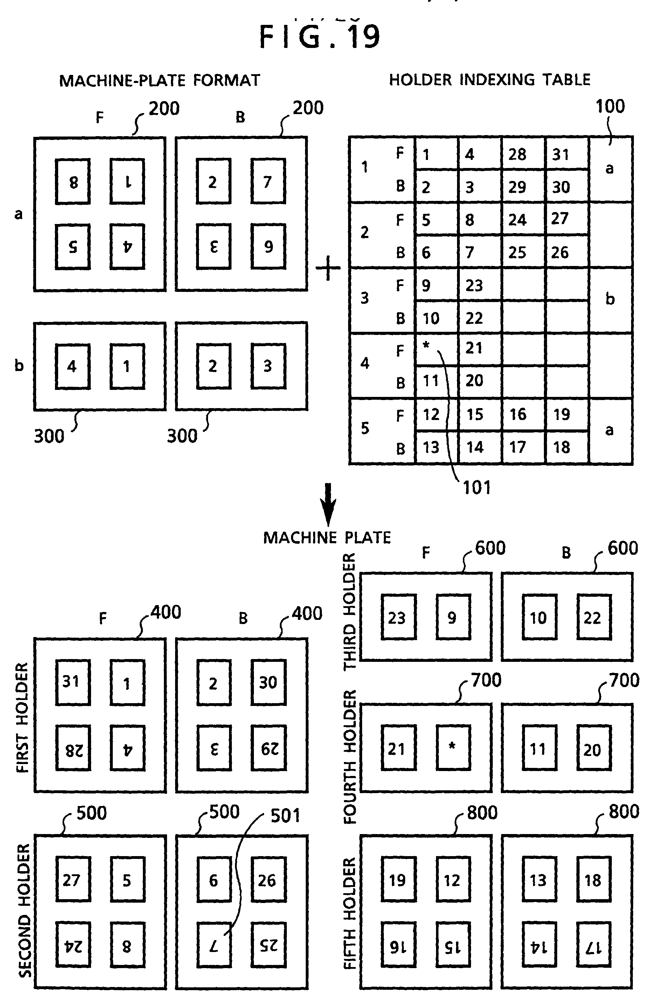

Next, procedure of the specific reproducing operation will be described with reference to Fig. 19. The reference numerals and characters applied in Fig. 19 correspond to the reference numerals and characters applied in Fig. 18.

Facing (layout) of first holder: It will be seen from the holder indexing table 100 that a plate format is [a], that is, a plate format indicated by the reference numeral 200 in Fig. 19. Pages are reproduced in order that the page number shown in the plate format 200 is small or less, from the left to the right of the holder indexing table, that is, pages 1, 4, 28 and 31 are reproduced on a front surface, and pages 2, 3, 29 and 30 are reproduced on a rear surface. The reproducing results are indicated by the reference numeral 400.

Facing (layout) of the second holder: As described previously, since the plate format in this case is likewise [a], order of reproducing pages is the same as that of the first holder. In this order, pages 5, 8, 24 and 27 in the holder indexing table are reproduced on the front surface, while pages 6, 7, 25 and 26 are reproduced to the rear surface. Thus, reproduction of a second holder is performed. The reproducing results are indicated by the reference numeral 500.

Facing (layout) of a third holder: Since it will be seen that a plate format is [b], that is, the plate format indicated by the reference numeral 300 in Fig. 19 from the holder indexing table, pages 9 and 23 in the holder indexing table are reproduced to the front surface, while pages 10 and 22 are reproduced to the rear surface, in accordance with the order of pages indicated in the plate format. Thus, reproduction to a third holder is performed. The reproducing results are indicated by the reference numeral 600. The Facing or layout is similarly performed with respect also to a fourth holder and a fifth holder.

The holder indexing table for side stitch or middle stitch made out as described above is prepared on the computer, and can be kept or stored as electronic information. Accordingly, the holder indexing table for side stitch or middle stitch can be called and displayed at any time on demand. Further, even if the holder indexing table is a holder indexing table once made out, it is easy to optionally change the contents of the holder indexing table, and it is also easy to display the changed holder indexing table. This is of great advantage. That is, if how to stitch (i.e. stitching method data), designation of the blank pages and releasing thereof is specified, since the number of reproductions for every holder and the like is redesignated, allocation of the pages is changed at once and is displayed on a picture and it is possible to easily consider the holder indexing table which is suited for a usable printing installation.

As described also previously, when a copy is reproduced on the plate for every single page in a plate-making step, the holder indexing table is used in order to arrange the copies in a predetermined order. The holder indexing table prepared in a manner described above can be used in the plate-making step which has been performed conventionally. However, since the holder indexing table can be stored in a file in the form of electronic information, if the DTP described previously and the holder indexing table are combined with each other, it is possible to extremely efficiently proceed with the preparation step and the proofreading step. In view of this, next, an example of making-out and a printing system will be described in which the DTP and the holder indexing table are combined with each other.

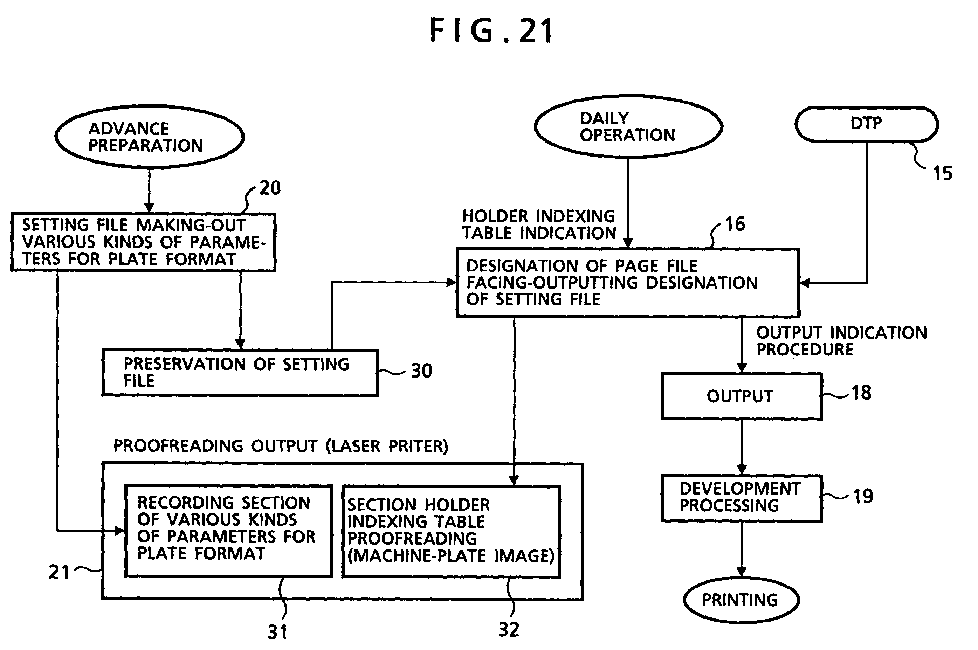

In Fig. 21, as an advance or pre-preparation, there is a making-out step 20 of a setting file. A made-out or prepared setting file is preserved by a preserving step 30 of the setting file. At the making-out step 20 of the setting file, various kinds of parameters for the plate format are made out on the computer as electronic information. As shown in Fig. 20, as the various kinds of parameters for the plate format, there are size or dimension of the plate in the widthwise direction and in the rotational direction, a widthwise size PW between pages, a size PH of the pages in a longitudinal direction, "ditch" between the pages in the widthwise direction, "ditch" between the pages in the longitudinal direction, a top margin TM, a left-hand margin LM, a gripper margin GR and the like. In addition thereto, there are various kinds of marks outside the pages, a register mark such as sections or the like, for example, signatures, nigger heads and the like. The contents of the setting file are outputted to a paper 31 by the proofreading output step 21 which uses a laser printer or the like, and can be applied to proofreading.

In the setting file made out and preserved, only things required in a holder indexing table indicating step 16 of daily operation are called. At the holder indexing table indicating step 16, a page file performing reproducing output among document data prepared at an editing assembled-plate making-out step 15 due to the DTP is also designated, and the page file is allocated in accordance with the setting file. In this manner, plate information in which the editing assembled plate, the holder indexing table, and the plate format are integrated with each other as described previously is prepared in the form of electronic information. The plate information made out is inputted to an output machine 18 by an output indicating procedure as described previously so that an image is formed on a direct machine plate or the like. The direct machine plate or the like on which the image is formed passes through a development processing step 19, whereby the direct machine plate or the like is completed as a machine plate, and can be used for printing. The plate information made out at the holder indexing table indicating step 16 can be outputted to the paper 32 in the proofreading output step 21. Proofreading can also be performed as occasion demands while seeing the paper.

According to the making-out and printing system described above, once the setting file is made out and is preserved as an advance preparation or pre-preparation, it is possible to select and call a suited file among stored setting files in daily or everyday operation, and to integrate document data with the called file to output the plate information so that a plate can be prepared. Accordingly, it is possible to efficiently proceed daily making-out operation.

In connection with the above, even in a case of special allocation called reversing and two-application in which the same document data are allocated on the same plate a plurality of times, there is a predetermined or constant order in the form of the allocation. Accordingly, in a case where reversing and two-application are designated, the document data are allocated in accordance with a predetermined or constant order, whereby it is possible to easily cope with the same.

In the embodiment described above, the plate format setting, the holder indexing setting, the page information making-out and the plate information making-out are processed consistently on the computer in the form of the electronic information. However, it is not necessarily required that all the setting-out is processed in the form of the electronic information. For example, in a case where the page information exists in the form of a copy such as a film or the like, the arrangement may be such that an automatic page sticking robot is used. The automatic page sticking robot is controlled by the plate setting file and the holder indexing tile, and the pages are reproduced on the direct machine plate or the like while sticking the copies to estimating positions by the robot one by one. In this case, it is required that the automatic page sticking robot has the followings features:
a. means for confirming pages of the copies;
b. means for selecting the copies of specific pages by indication from a holder indexing file; and
c. function of arranging the copies selected by the indication from the plate setting file, to predetermined position and direction.
d. In addition thereto, it is further desirable that the automatic page sticking robot has a function for automatically arranging the copies of the information out of the pages such as various kinds of register marks or the like.

Thus, if the copies are exposed to a plate material under a condition that the copies are stuck by the automatic page sticking robot, there can be produced machine plate reproduction to multiple pages.

Further, the above-described automatic page sticking robot may be combined with a process camera which is capable of optionally controlling a platen and a mask plate, disclosed in the aforesaid Japanese Patent Laid-Open No. 3-45941. The automatic page sticking robot in this case may have the above-mentioned means a and b.

According to the embodiment of the invention, there can be produced the following advantage. That is, in Fig. 1, according to the embodiment of the automatic preparation apparatus for the holder indexing table of the invention, when the data of the number of total pages of the printed matter, the data of the number of reproductions for every plate, and the data of how to stitch are inputted, the page allocation executing section 7 computes the number of holders required for printing the number of total pages by the data of total pages stored in the page data managing section 6 and the data of the number of reproductions which are preserved in the retaining section 8 of the number of reproduction data. Moreover, the page allocation executing section 7 sets the number of pages to be entered into a single plate. The page allocation executing section 7 performs allocation of the pages with the set number of pages at a time, for every table of the number of tables found by computation, in accordance with the order determined by the data of how to stitch. Thus, it is possible to automatically prepare the holder indexing table by the use of the computer or the like. It is not required to prepare the holder indexing table by manual operation as is in a conventional one. Thus, it is possible to prepare the holder indexing table extremely efficiently. Mistakes during the preparation are also eliminated.

In connection with the above, even in a case of special allocation called reversing and two-application in which the same document data are allocated to the same plate a plurality of times, there is a predetermined or constant order in the form of the allocation. Accordingly, in a case where the reversing and the two-application are designated, the document data are allocated in accordance with the predetermined order, whereby it is possible to easily cope with the specific or special allocation.

In a case where a blank page is set, the setting is performed by a data processing method in which page data shift in order at pages subsequent to the blank page in the example shown in Fig. 16.

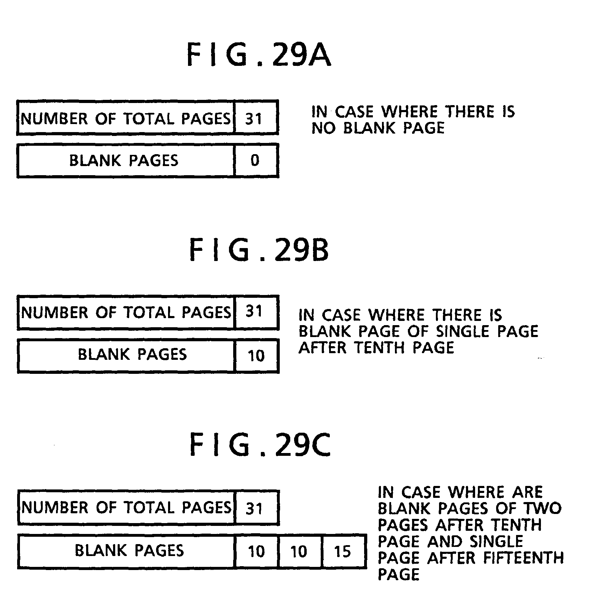

However, the invention should not be limited to this specific arrangement. A processing method illustrated in Fig. 15 may be used or adopted. That is, in a case where there is no blank page, setting is made such that the blank page is [0] as shown in Fig. 29A. In a case where there is a blank page, a page tending to be used in the blank is set by a numeral, as shown in Fig. 29A and 29C. Fig. 29B shows a case where there is a blank page by an amount corresponding to a single page, at a location subsequent to a tenth page, and setting is made to a blank page [10]. Fig. 29C shows a case where there is a blank page corresponding to two pages, at a location subsequent to the tenth page, and there is the blank page corresponding to a single page, at a location subsequent to the fifteenth page. Thus, a setting is made for the blank pages [10, 10, 15].

According to the invention, the machine-plate format data are made out by the step of setting the machine-plate format data or by the means for setting the machine-plate format data. The holder indexing data are made out by the holder-indexing setting step or the holder-indexing setting means, on the basis of the data of the number of total pages of the printed matter, the data of the number of reproductions per plates, and the data of how to stitch. The page information made out beforehand is allocated, on the basis of the data of the machine-plate format data and the holder indexing data, to make out the plate information required for the machine plate. Accordingly, it is made possible to use the computer or the like to automatically and consistently prepare the plate information. Thus, it is possible to make out the plate information extremely efficiently. It is possible to also eliminate mistakes during the preparation.

Further, since the plate information prepared can be preserved or stored as the electronic information, it is possible to anytime call and display the plate information as occasion demands. Even if the plate information has been prepared, it is easy to optionally change the contents of the plate information, and it is easy also to display the changed plate information.

According to the invention, if the data of the number of total pages of the printed matter, the data of the number of reproductions per each plate and the data of how to stick are inputted, the page allocation executing section computes the number of holders required to print the number of total pages, by the data of the number of total pages preserved in the page data managing section and the data of the number of reproductions retained in the number of reproduction data retaining section, and sets the number of pages to be entered into a single plate. In accordance with the order determined by the data of how to stitch, the page allocation executing section performs allocation of pages for the respective number of pages set at a time, for each table within the determined number of holders which is found by computation. Accordingly, it is made possible to use the computer or the like to automatically prepare the holder indexing table. Thus, it is possible to make out the holder indexing table extremely efficiently, and mistakes can also be eliminated.

Moreover, even if there are blank pages, even if the number of reproductions per each plate on the way is changed, and even if the special reproductions such as reversing, two-application and the like are included, it is possible to pliantly or flexibly cope with these facts to automatically make out the holder indexing table. Accordingly, efficient making-out of the holder indexing table is possible also in this respect, and mistakes of making-out can be eliminated.

Furthermore, the section outputting of each plate is performed. By doing so, it is possible to confirm whether or not the holder indexing table or the reproducing format is correctly set when preparing an objective publication or document.

Further, since the made-out holder indexing table can be kept or stored as the electronic information, it is possible to anytime call the holder indexing table and to display the same as occasion demands. Even the holder indexing table once made out, it is easy to optionally change the contents of the holder indexing table, and it is easy also to display the changed holder indexing table. Moreover, since the image can be formed under a condition that the complete copy for each page made out in the form of electronic information is faced electronically on the machine plate in the predetermined form, it is made possible to extremely efficiently proceed with the making-out operation.

## Claims

1. An apparatus for preparing a table (e.g. 100) used for printing a document consisting of a number of pages, said table indicating an arrangment layout of the pages on a set of front/back printing plates (28) for printing said pages on individual sheets of printing paper, comprising:
**a)** an input means (1, 2, 4; 23, 24) adapted for inputting document data including at least page number data indicating the total number of pages of said document, number data indicating the number of pages placed on each side of said printing plates and stitch data indicating a predetermined method of stitching the printed sheets into the finished document when they have been printed; and
**b)** a page allocation executing means (7) adapted for setting in the table (100) for each printing plate front/back side indications of the page numbers to be printed in accordance with the number of pages placed on each side of the printing plates and the total number of pages and in an order as determined by the stitch data.

2. An apparatus according to claim 1,
***characterized in that***
the page allocation means (7) is further adapted for calculating the number of printing plates on the basis of the total number of pages and the number of pages placed on each side of the printing plates.

3. An apparatus according to claim 1,
***characterized in that***
said input means is further adapted to input blank page data indicating a location between two pages where a blank page is to inserted, wherein said page allocation execution means (7) is adapted to set said front/back side indications of the page numbers to be printed also in accordance with the blank page data.

4. An apparatus according to claim 1,
***characterized in that***
said page allocation execution means (7) is adapted to set said front/back side indications of the page numbers to be printed for a plurality of printing plates, wherein said number data indicating the number of pages placed on each side of said printing plates indicate a different number of pages for at least two different printing plates.

5. An apparatus according to claim 1,
***characterized in that***
said input means is further adapted to input special print data indicating a reversing print technique or a two-application print technique, wherein said page allocation execution means (7) is adapted to set said front/back side indications of the page numbers to be printed also in accordance with the special print data.

6. An apparatus according to claim 1,
***characterized in that***
said page allocation execution means (7) is further adapted to determine the orientation of the pages on the printing plates, wherein a section preparation means (57) is adapted to prepare the layout of the pages for each printing plate front/back side and an output means is adapted to output the layout with the page numbers in an order and an orientation as determined by the page allocation means and the layout prepartion means (57).

7. An apparatus according to claim 1,
***characterized by***
a plate format input means (23) for inputting plate format data indicating the arrangement format (TM, LM, PW, PH, GR) of pages on each front/back side of the printing plates (28).

8. A method for preparing a table (e.g. 100) used for printing a document consisting of a number of pages, said table indicating an arrangment layout of the pages on a set of front/back printing plates (28) for printing said pages on individual sheets of printing paper, comprising th following steps:
**a)** inputting document data including at least page number data indicating the total number of pages of said document, number data indicating the number of pages placed on each side of said printing plates and stitch data indicating a predetermined method of stitching the printed sheets into the finished document when they have been printed; and
**b)** setting in the table (100) for each printing plate front/back side indications of the page numbers to be printed in accordance with the number of pages placed on ech side of the printing plates and the total number of pages and in an order as determined by the stitch data.

## Patentansprüche

1. Vorrichtung zum Erstellen einer Tabelle (z.B. 100), die zum Drucken eines Dokuments verwendet wird, das aus einer Anzahl von Seiten besteht, wobei die Tabelle ein Anordnungslayout der Seiten auf einem Satz von vorderen/hinteren Druckplatten (28) zum Drucken der Seiten auf einzelne Blätter eines Druckpapiers anzeigt, umfassend:
**a)** eine Eingabeeinrichtung (1, 2, 4; 23, 24), die zum Eingeben von Dokumentendaten aussgelegt ist, die wenigstens Seitenanzahidaten, die die Gesamtanzahl von Seiten des Dokuments anzeigen, Nummerndaten, die die Seitennummern anzeigen, die auf jede Seite der Druckplatten plaziert werden, und Stichdaten, die ein vorgegebenes Stichverfahren für die gedruckten Blätter in das fertiggestellte Produkt, wenn sie gedruckt worden sind, anzeigen, umfassen; und
**b)** eine Seitenzuordnungs-Ausführungseinrichtung (7), die dafür ausgelegt ist, um in der Tabelle (100) für jede Druckplatte Vorder/Rückseiten-Anzeigen der Seitennummern einzustellen, die gemäß der Anzahl von Seiten, die auf jeder Seite der Druckplatten angeordnet sind, und der Gesamtanzahl von Seiten und in einer Ordnung wie von den Stichdaten bestimmt gedruckt werden sollen.

2. Vorrichtung nach Anspruch 1,
**dadurch gekennzeichnet, dass**
die Seitenzuordnungseinrichtung (7) ferner dafür ausgelegt ist, um die Anzahl von Druckplatten auf Grundlage der Gesamtanzahl von Seiten und der Anzahl von Seiten, die auf jeder Seite der Druckplatten angeordnet werden, zu berechnen.

3. Vorrichtung nach Anspruch 1,
**dadurch gekennzeichnet, dass**
die Eingabeeinrichtung ferner dafür ausgelegt ist, um Leerseitendaten einzugeben, die eine Stelle zwischen zwei Seiten anzeigen, an der eine Leerseite eingefügt werden soll, wobei die Seitenzuordnungs-Ausführungseinrichtung (7) ausgelegt ist, um die Vorder/Rückseiten-Anzeigen der Seitennummern, die gedruckt werden sollen, auch gemäß der Leerseitendaten einzustellen.

4. Vorrichtung nach Anspruch 1,
**dadurch gekennzeichnet, dass**
die Seitenzuordnungs-Ausführungseinrichtung (7) dafür ausgelegt ist, um die Vorder/Rückseiten-Anzeigen der Seitennummern, die gedruckt werden sollen, für eine Vielzahl von Druckplatten einzustellen, wobei die Nummerndaten, die die Anzahl von Seiten anzeigen, die auf jeder Seite der Druckplatten angeordnet werden, eine unterschiedliche Anzahl von Seiten für wenigstens zwei unterschiedliche Druckplatten anzeigen.

5. Vorrichtung nach Anspruch 1,
**dadurch gekennzeichnet, dass**
die Eingabeeinrichtung ferner dafür ausgelegt ist, um Spezialdruckdaten einzugeben, die eine UmkehrungsDrucktechnik oder eine Doppelanwendungs-Drucktechnik anzeigen, wobei die Seitenzuordnungs-Ausführungseinrichtung (7) dafür ausgelegt ist, um die Vorder/Rückseiten-Anzeigen der Seitennummern, die gedruckt werden sollen, auch gemäß der Spezialdruckdaten einzustellen.

6. Vorrichtung nach Anspruch 1,
**dadurch gekennzeichnet, dass**
dass die Seitenzuordnungs-Ausführungseinrichtung (7) ferner dafür ausgelegt ist, um die Orientierung der Seiten auf den Druckplatten zu bestimmen, wobei eine Abschnitts-Erstellungseinrichtung (57) dafür ausgelegt ist, um das Layout der Seiten für jede Druckplatten-Vorder/Rückseite zu erstellen, und eine Ausgabeeinrichtung ausgelegt ist, um das Layout mit den Seitennummern in einer Ordnung und einer Orientierung, wie von der Seitenzuordnungseinrichtung und der Layout-Erstellungseinrichtung (57) bestimmt, auszugeben.

7. Vorrichtung nach Anspruch 1,
**gekennzeichnet durch**
eine Plattenformat-Eingabeeinrichtung (23) zum Eingeben von Plattenformatdaten, die das Anordnungsformat (TM, LM, PW, PH, GR) von Seiten auf jeder Vorder/Rückseite der Druckplatten (28) anzeigen.

8. Verfahren zum Erstellen einer Tabelle (z.B. 100), die zum Drucken eines Dokuments verwendet wird, welches aus einer Anzahl von Seiten besteht, wobei die Tabelle ein Anordnungslayout der Seiten auf einem Satz von vorderen/hinteren Druckplatten (28) zum Drucken der Seiten auf einzelne Blätter eines Druckpapiers anzeigt, umfassend die folgenden Schritte:
**a)** Eingeben von Dokumentendaten, die wenigstens Seitennummerndaten, die die Gesamtanzahl von Seiten des Dokuments anzeigen, Nummerndaten, die die Seitennummern anzeigen, die auf jeder Seite der Druckplatten angeordnet werden, und Stichdaten, die ein vorgegebenes Stichverfahren für die gedruckten Blätter in das fertiggestellte Dokument hin anzeigen, wenn sie gedruckt worden sind, umfassen; und
**b)** Einstellen in der Tabelle (100) für jede Druckplatte von Vorder/Rückseiten-Anzeigen der Seitennummern, die gemäß der Anzahl von Seiten, die auf jeder Seite der Druckplatten angeordnet werden, und der Gesamtanzahl von Seiten und in einer Ordnung wie von den Stichdaten bestimmt gedruckt werden sollen.

## Revendications

1. Un appareil pour préparer un tableau (par exemple 100) utilisé pour imprimer un document consistant en un certain nombre de pages, ce tableau indiquant une disposition des pages sur un ensemble de formes imprimantes recto/verso (28) pour imprimer ces pages sur des feuilles individuelles de papier d'impression, comprenant :
a) des moyens d'entrée (1, 2, 4; 23, 24) adaptés pour introduire des données de document comprenant au moins des données de nombre de pages indiquant le nombre total de pages du document, des données de nombre indiquant le nombre de pages placées sur chaque face des formes imprimantes, et des données de brochure indiquant un procédé prédéterminé pour assembler les feuilles imprimées pour former le document fini lorsqu'elles ont été imprimées; et
b) des moyens d'exécution d'allocation de pages (7) adaptés pour placer dans le tableau (100), pour chaque forme imprimante, des indications recto/verso des nombres de pages à imprimer, conformément au nombre de pages qui sont placées sur chaque face des formes imprimantes, et au nombre total de pages, et dans un ordre qui est déterminé par les données de brochure.

2. Un appareil selon la revendication 1,
caractérisé en ce que
les moyens d'allocation de pages (7) sont en outre adaptés pour calculer le nombre de formes imprimantes sur la base du nombre total de pages et du nombre de pages placées sur chaque face des formes imprimantes.

3. Un appareil selon la revendication 1,
caractérisé en ce que
les moyens d'entrée sont en outre adaptés pour introduire des données de page en blanc indiquant un emplacement entre deux pages auquel une page en blanc doit être insérée, dans lequel les moyens d'exécution d'allocation de pages (7) sont adaptés pour fixer les indications de recto/verso des nombres de pages à imprimer, également en conformité avec les données de page en blanc.

4. Un appareil selon la revendication 1,
caractérisé en ce que
les moyens d'exécution d'allocation de pages (7) sont adaptés pour fixer les indications de recto/verso des nombres de pages à imprimer pour une multiplicité de formes imprimantes, dans lequel les données de nombres indiquant le nombre de pages placées sur chaque face des formes imprimantes indiquent un nombre de pages différent pour au moins deux formes imprimantes différentes.

5. Un appareil selon la revendication 1,
caractérisé en ce que
les moyens d'entrée sont en outre adaptés pour introduire des données d'impression spéciale indiquant une technique d'impression avec retournement ou une technique d'impression en deux applications, dans lequel les moyens d'exécution d'allocation de pages (7) sont adaptés pour fixer les indications de recto/verso des nombres de pages à imprimer, également en conformité avec les données d'impression spéciale.

6. Un appareil selon la revendication 1,
caractérisé en ce que
les moyens d'exécution d'allocation de pages (7) sont en outre adaptés pour déterminer l'orientation des pages sur les formes imprimantes, dans lequel des moyens de préparation de section (57) sont adaptés pour préparer la disposition des pages pour chaque face recto/verso de forme imprimante, et des moyens de sortie sont adaptés pour fournir en sortie la disposition avec les nombres de pages, dans un ordre et une orientation qui sont déterminés par les moyens d'allocation de pages et les moyens de préparation de disposition (57).

7. Un appareil selon la revendication 1,
caractérisé par
des moyens d'entrée de format de forme imprimante (23), pour introduire des données de format de forme imprimante indiquant le format de disposition (TM, LM, PW, PH, GR) de pages sur chaque face recto/verso des formes imprimantes (28).

8. Un procédé pour préparer un tableau (par exemple 100) utilisé pour imprimer un document consistant en un certain nombre de pages, ce tableau indiquant une disposition des pages sur un ensemble de formes imprimantes recto/verso (28), pour l'impression des pages sur des feuilles individuelles de papier d'impression, comprenant les étapes suivantes :
a) on introduit des données de document comprenant au moins des données de nombre de pages indiquant le nombre total de pages du document, des données de nombre indiquant le nombre de pages placées sur chaque face des formes imprimantes, et des données de brochure indiquant un procédé prédéterminé pour l'assemblage des feuilles imprimées pour donner le document fini, lorsqu'elles ont été imprimées; et
b) on place dans le tableau (100) pour chaque forme imprimante, des indications de recto/verso des nombres de pages à imprimer conformément au nombre de pages placées sur chaque face des formes imprimantes, et au nombre total de pages, et dans un ordre qui est déterminé par les données de brochure.
